# EUROPEAN PATENT APPLICATION

(11) **EP 4 496 002 A1**
(43) Date of publication of application: **22.01.2025**
(21) Application number: 23771074.4
(22) Date of filing: 15.03.2023
(51) Int. Cl.: H01L 27/12, H01L 33/64, H01L 33/50, H01L 33/58, H01L 27/15

(54) **DISPLAY DEVICE**

(30) Priority: 17.03.2022 KR 20220033549
(71) Applicant: Samsung Display Co., Ltd., Gyeonggi-do 17113 (KR)
(72) Inventor: CHO, Kyu Won, Yongin-si Gyeonggi-do 17113 (KR); KANG, Suk Hoon, Yongin-si Gyeonggi-do 17113 (KR)
(74) Representative: Marks & Clerk LLP
(86) International application number: PCT/KR2023/003432
(87) International publication number: WO 2023/177195

(57) **Abstract**

A display device is provided. The display device includes a plurality of subpixels, each including a first electrode and a second electrode spaced apart from one another, and light-emitting elements electrically connected to the first electrode and the second electrode, a bank layer surrounding an area in which the light-emitting elements are disposed, a thermal control layer disposed in the area surrounded by the bank layer, to cover the light-emitting elements, an upper bank layer disposed on the bank layer, and a color control layer disposed on the thermal control layer, in an area surrounded by the upper bank layer, wherein the thermal control layer includes a resin layer, and a phase change particle dispersed in the resin layer and including a core including a phase change material, and a first shell surrounding the cores.

## Description

### [TECHNICAL FIELD]

The present disclosure relates to a display device.

### [BACKGROUND ART]

Display devices are becoming more important with developments in multimedia technology. Accordingly, various display devices such as an organic light-emitting diode (OLED) display device, a liquid crystal display (LCD) device, and the like have been used.

For example, there are self-luminous display devices including light-emitting elements. Examples of the self-luminous display devices include an organic light-emitting display device using an organic material as a light-emitting material and an inorganic light emitting display device using an inorganic material as a light-emitting material.

### [DISCLOSURE]

### [TECHNICAL PROBLEM]

Aspects of embodiments of the present disclosure provide a display device capable of effectively or suitably controlling heat generated by light-emitting elements.

It should be noted that aspects of the present disclosure are not limited to the above-mentioned aspects, and other unmentioned aspects of the present disclosure will be clearly understood by those skilled in the art from the following descriptions.

### [TECHNICAL SOLUTION]

According to an embodiment of the disclosure, a display device comprises a plurality of subpixels, each including a first electrode and a second electrode spaced apart from one another, and light-emitting elements electrically connected to the first electrode and the second electrode, a bank layer surrounding an area in which the light-emitting elements are disposed, a thermal control layer disposed in the area surrounded by the bank layer, to cover the light-emitting elements, an upper bank layer disposed on the bank layer, and a color control layer disposed on the thermal control layer, in an area surrounded by the upper bank layer, wherein the thermal control layer includes a resin layer, and a phase change particle dispersed in the resin layer and including a core including a phase change material, and a first shell surrounding the cores.

The core may include at least one of dodecane, docosane, and an aluminium-silicon alloy, and the first shell may include at least one of polystyrene, polymethylmethacrylate, aluminium oxide, and polymethylmethacrylate-silica.

The phase change particle may further include a second shell surrounding the core and including a thermal conductive material, and the first shell may surround the second shell.

The second shell may include at least one of graphite, carbon black, and a conductive polymer.

The phase change particle may have a diameter of 1 µm or less.

The resin layer of the thermal control layer may include one of an epoxy resin, an acrylic resin, a cardo resin, and an imide resin.

The thermal control layer may further include a scatterer.

The color control layer may have a greater thickness than the thermal control layer.

The color control layer may have a thickness of 8 µm to 10 µm, and the thermal control layer may have a thickness of about 2 µm.

The display device may further comprise a first insulating layer disposed on the first electrode and the second electrode, a second insulating layer disposed on the light-emitting elements and the bank layer, and a third insulating layer disposed on the second insulating layer and the bank layer, wherein the bank layer may be disposed on the first insulating layer.

A height of a top surface of the thermal control layer may be the same as, or less than, a height of a top surface of the third insulating layer on the bank layer.

A height of a top surface of the thermal control layer may be greater than a height of a top surface of the third insulating layer on the bank layer.

Parts of sides of the thermal control layer may be in contact with the upper bank layer.

At least a portion of the thermal control layer may be disposed on the bank layer, and the color control layer and the upper bank layer may be disposed on the thermal control layer.

The color control layer may include a first wavelength conversion layer disposed in a first subpixel and including a first wavelength conversion particle, a second wavelength conversion layer disposed in a second subpixel and including a second wavelength conversion particle, and a light-transmitting layer disposed in a third subpixel and including a scatterer, and the thermal control layer may be disposed between the first wavelength conversion layer, the second wavelength conversion layer, and the light-transmitting layer of the color control layer and the light-emitting elements.

The display device may further comprise a first connecting electrode in contact with the light-emitting elements and disposed on the first electrode, and a second connecting electrode in contact with the light-emitting elements and disposed on the second electrodes.

According to an embodiment of the disclosure, a display device comprises a plurality of subpixels, each including a first electrode and a second electrode spaced apart from one another, and light-emitting elements electrically connected to the first electrode and the second electrode, a bank layer surrounding an area in which the light-emitting elements are disposed, an upper bank layer disposed on the bank layer, and a color control layer disposed on the light-emitting elements, in an area surrounded by the upper bank layer, wherein the color control layer includes a first wavelength conversion layer disposed in a first subpixel and including a first wavelength conversion particle, a second wavelength conversion layer disposed in a second subpixel and including a second wavelength conversion particle, and a light-transmitting layer disposed in a third subpixel and including a scatterer, and the first wavelength conversion layer, the second wavelength conversion layer, and the light-transmitting layer include a phase change particle including a core including a phase change material, and a first shell surrounding the core.

The core may include at least one of dodecane, docosane, and an aluminium-silicon alloy, and the first shell may include at least one of polystyrene, polymethylmethacrylate, aluminium oxide, and polymethylmethacrylate-silica.

The phase change particle may further include a second shell surrounding the core and including a thermal conductive material, and the first shell may surround the second shell.

The phase change particle may have a diameter of 1 µm or less.

The details of other embodiments are included in the detailed description and the accompanying drawings.

### [ADVANTAGEOUS EFFECTS]

According to embodiments of the present disclosure, a display device may include a thermal control layer, which is disposed between a color control layer and light-emitting elements. As the thermal control layer includes a phase change material, heat generated by the light-emitting elements can be effectively controlled.

Therefore, the display device can reduce any thermal deformation of the color control layer that may be caused by the heat generated by the light-emitting elements, and the product and the life of the display device can be improved.

The effects according to the embodiments are not limited by the contents exemplified above, and more various effects are included in this disclosure.

### [DESCRIPTION OF DRAWINGS]

FIG. 1 is a plan view of a display device according to an embodiment of the disclosure;
FIG. 2 is a plan view illustrating the layout of a plurality of lines in the display device of FIG. 1;
FIGS. 3 and 4 are circuit diagrams of subpixels of the display device of FIG. 1;
FIG. 5 is a plan view of a pixel of the display device of FIG. 1;
FIG. 6 is a cross-sectional view taken along line N1-N1' of FIG. 5;
FIG. 7 is a cross-sectional view taken along line N2-N2' of FIG. 5;
FIG. 8 is a cross-sectional view taken along line N3-N3' of FIG. 5;
FIG. 9 is a cross-sectional view illustrating a color control layer and a thermal control layer in a pixel of the display device of FIG. 1;
FIG. 10 is a cross-sectional view illustrating a first wavelength conversion layer and a thermal control layer in a first subpixel of FIG. 9;
FIG. 11 illustrates phase change particles in a thermal control layer of the display device of FIG. 1;
FIG. 12 illustrates phase change particles in a thermal control layer of a display device according to another embodiment of the disclosure;
FIG. 13 is a perspective view of a light-emitting element according to an embodiment of the disclosure;
FIG. 14 is a cross-sectional view illustrating a wavelength conversion layer and a thermal control layer in a subpixel of a display device according to another embodiment of the disclosure;
FIG. 15 is a cross-sectional view illustrating a color control layer and a thermal control layer in a pixel of a display device according to another embodiment of the disclosure;
FIG. 16 is a cross-sectional view illustrating a color control layer and a thermal control layer in a pixel of a display device according to another embodiment of the disclosure; and
FIG. 17 is a cross-sectional view illustrating a wavelength conversion layer and a thermal control layer in a subpixel of a display device according to another embodiment of the disclosure.

### [MODES OF THE INVENTION]

The present disclosure will now be described more fully hereinafter with reference to the accompanying drawings, in which preferred embodiments of the disclosure are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Hereinafter, embodiments will be described with reference to the accompanying drawings.

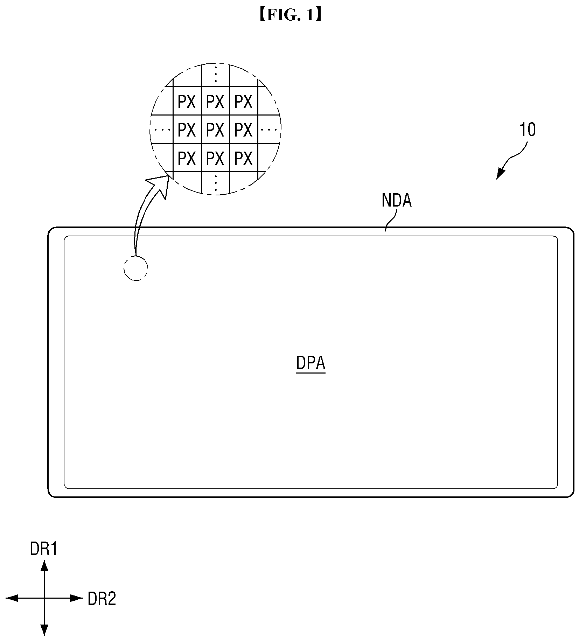

FIG. 1 is a plan view of a display device according to an embodiment of the disclosure.

Referring to FIG. 1, a display device 10 displays a moving or still image. The display device 10 may refer to nearly all types of electronic devices that provide a display screen. Examples of the display device 10 may include a television (TV), a notebook computer, a monitor, a billboard, an Internet-of-Things (IoT) device, a mobile phone, a smartphone, a tablet personal computer (PC), an electronic watch, a smartwatch, a watchphone, a head-mounted display (HMD), a mobile communication terminal, an electronic notepad, an electronic book (e-book), a portable multimedia player (PMP), a navigation device, a gaming console, a digital camera, a camcorder, and the like.

The display device 10 includes a display panel that provides a display screen. Examples of the display panel of the display device 10 include an inorganic light-emitting diode (LED) display panel, an organic light-emitting diode (OLED) display panel, a quantum-dot light-emitting diode (QLED) display panel, a plasma display panel (PDP), a field-emission display (FED) panel, and the like. The display panel of the display device 10 will hereinafter be described as being, for example, an inorganic LED display panel, but the disclosure is not limited thereto. That is, various other display panels are also applicable to the display panel of the display device 10.

The shape of the display device 10 may vary. For example, the display device 10 may have a rectangular shape that extends longer in a horizontal direction than in a vertical direction, a rectangular shape that extends longer in the vertical direction than in the horizontal direction, a square shape, a tetragonal shape with rounded corners, a non-tetragonal polygonal shape, or a circular shape. The shape of a display area DPA of the display device 10 may be similar to the shape of the display device 10. FIG. 1 illustrates that the display device 10 and the display area DPA both have a rectangular shape that extends in a second direction DR2.

The display device 10 may include the display area DPA and a non-display area NDA. The display area DPA may be an area in which a screen is displayed, and the non-display area NDA may be an area in which a screen is not displayed. The display area DPA may also be referred to as an active area, and the non-display area NDA may also be referred to as an inactive area. The display area DPA may occupy the middle part of the display device 10.

The display area DPA may include a plurality of pixels PX. The pixels PX may be arranged in row and column directions. Each of the pixels PX may have a rectangular or square shape in a plan view, but the disclosure is not limited thereto. Alternatively, each of the pixels PX may have a rhombus shape having sides inclined with respect to a particular direction. The pixels PX may be arranged in a stripe fashion or an island fashion. Each of the pixels PX may include one or more light-emitting elements, which emit light of a particular wavelength band.

The non-display area NDA may be disposed around the display area DPA. The non-display area NDA may surround the entire display area DPA or part of the display area DPA. The display area DPA may have a rectangular shape, and the non-display area NDA may be disposed adjacent to four sides of the display area DPA. The non-display area NDA may form the bezel of the display device 10. Lines or circuit drivers included in the display device 10 may be disposed in the non-display area NDA, or external devices may be mounted in the non-display area NDA.

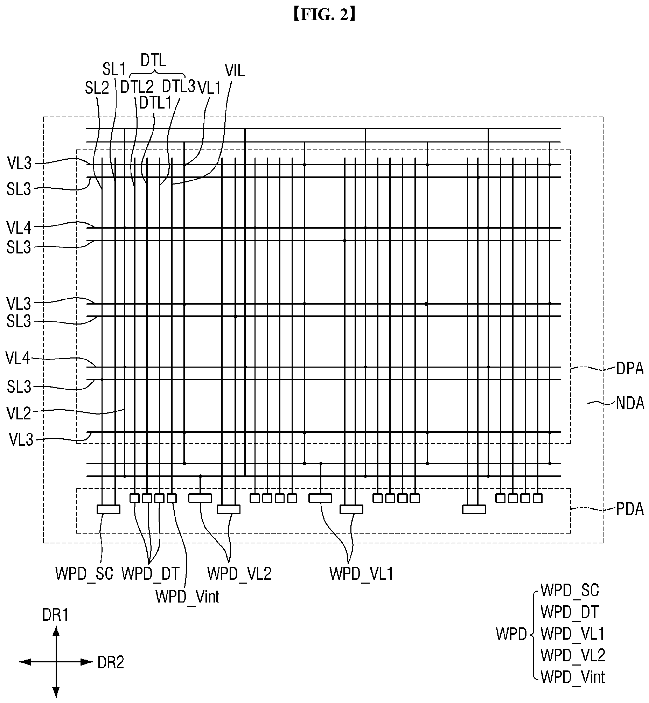

FIG. 2 is a plan view illustrating the layout of a plurality of lines in the display device of FIG. 1.

Referring to FIG. 2, the display device 10 may include a plurality of lines. The display device 10 may include a plurality of scan lines SL, a plurality of data lines DTL, initialization voltage lines VIL, and a plurality of voltage lines VL. Although not specifically illustrated, the display device 10 may further include other lines. The lines of the display device 10 may include lines that are formed of a first conductive layer and extend in the first direction DR1, lines that are formed of a third conductive layer and extend in the second direction DR2, but the disclosure is not limited thereto.

First scan lines SL1 and second scan lines SL2 may extend in the first direction DR1. A set of first and second scan lines SL1 and SL2 may be disposed adjacent to each other and may be spaced apart from other sets of first and second scan lines SL1 and SL2 in the second direction DR2. The first scan lines SL1 and the second scan lines SL2 may be connected to scan line wire pads WPD_SC, which are connected to a scan driver (not illustrated). The first scan lines SL1 and the second scan lines SL2 may extend from a pad area PDA in the non-display area NDA to the display area DPA.

Third scan lines SL3 may extend in the second direction DR2 and may be spaced apart from one another in the first direction DR1. Each of the third scan lines SL3 may be connected to one or more first scan lines SL1 or one or more second scan lines SL2. The scan lines SL may form a mesh structure over the entire display area DPA, but the disclosure is not limited thereto.

The data lines DTL may extend in the first direction DR1. The data lines DTL may include first data lines DTL1, second data lines DTL2, and third data lines DTL3, and one first data line DTL1, one second data line DTL2, and one third data line DTL3 may be paired together to be disposed adjacent to one another. The data lines DTL may extend from the pad area PDA in the non-display area NDA to the display area DPA. However, the disclosure is not limited to this. Alternatively, the data lines DTL may be arranged at equal intervals between first voltage lines VL1 and second voltage lines VL2.

The initialization voltage lines VIL may extend in the first direction DR1. The initialization voltage lines VIL may be disposed between the data lines DTL and the first voltage lines VL1. The initialization voltage lines VIL may extend from the pad area PDA in the non-display area NDA to the display area DPA.

The first volage lines VL1 and the second voltage lines VL2 may extend in the first direction DR1, and third voltage lines VL3 and fourth voltage lines VL4 may extend in the second direction DR2. The first volage lines VL1 and the second voltage lines VL2 may be alternately arranged in the second direction DR2, and the third voltage lines VL3 and the fourth voltage lines VL4 may be alternately arranged in the first direction DR1. The first voltage lines VL1 and the second voltage lines VL2 may extend in the first direction DR1 across the display area DPA. Some of the third voltage lines VL3 and some of the fourth voltage lines VL4 may be disposed in the display area DPA, and the other third voltage lines VL3 and the other fourth voltage lines VL4 may be disposed in the non-display area NDA, on both sides, in the first direction DR1, of the display area DPA. The voltage lines VL may form a mesh structure over the entire display area DPA. However, the disclosure is not limited to this.

Each of the first scan lines SL1, the second scan lines SL2, the data lines DTL, the initialization voltage lines VIL, the first voltage lines VL1, and the second voltage lines VL2 may be electrically connected to one or more wire pads WPD. The wire pads WPD may be disposed in the non-display area NDA. The wire pads WPD may also be disposed in the pad area PDA on a second side, in the first direction DR1, of the display area DPA, e.g., on the lower side of the display area DPA. The first scan lines SL1 and the second scan lines SL2 may be connected to the scan line wire pads WPD_SC, and the data lines DTL may be connected to different data line wire pads WPD_DT. The initialization voltage lines VIL may be connected to initialization line wire pads WPD_Vint, the first voltage lines VL1 may be connected to first voltage line wire pads WPD_VL1, and the second voltage lines VL2 may be connected to second voltage line wire pads WPD_VL2. External devices may be mounted on the wire pads WPD. The external devices may be mounted on the wire pads WPD via anisotropic conductive films or ultrasonic bonding. The wire pads WPD are illustrated as being disposed in the pad area PDA on the lower side of the display area DPA, but the disclosure is not limited thereto. Alternatively, some of the wire pads WPD may be disposed on the upper side of the display area DPA or on the left or right side of the display area DPA.

A pixel PX or a subpixel SPXn (where n is an integer of 1 to 3) of the display device 10 includes a pixel driving circuit. The above-described lines of the display device 10 may apply driving signals to the pixel driving circuit, passing by the pixel or the subpixel SPXn. The pixel driving circuit may include transistors and capacitors. The numbers of transistors and capacitors included in the pixel driving circuit may vary. For example, the pixel driving circuit may have a "3T1C" structure including three transistors and one capacitor. The pixel driving circuit will hereinafter be described as having the "3T1C" structure, but the disclosure is not limited thereto. Alternatively, various other structures such as a "2T1 C", "7T1 C", or "6T1 C" structure may also be applicable to the pixel driving circuit.

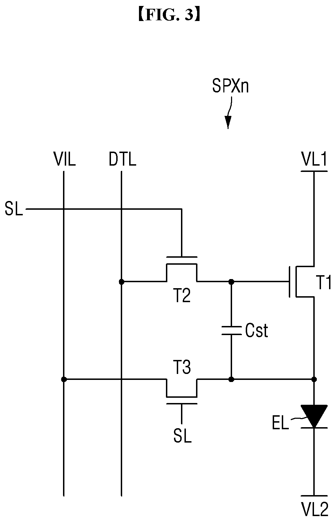

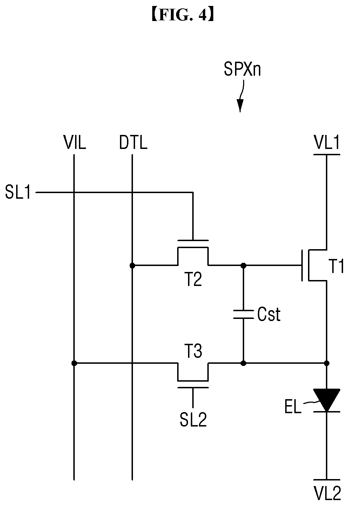

FIGS. 3 and 4 are circuit diagrams of subpixels of the display device of FIG. 1.

Referring to FIG. 3, a subpixel SPXn of the display device 10 includes a light-emitting diode (LED) "EL", three transistors, i.e., first, second, and third transistors T1, T2, and T3, and one storage capacitor Cst.

The LED "EL" emits light in accordance with a current applied thereto via the first transistor T1. The LED "EL" includes a first electrode, a second electrode, and at least one light-emitting element disposed between the first and second electrodes. The light-emitting element may emit light of a particular wavelength band in accordance with electric signals transmitted thereto from the first and second electrodes.

A first end of the LED "EL" may be connected to the source electrode of the first transistor T1, and a second end of the LED "EL" may be connected to a second voltage line VL2, to which a low-potential voltage (hereinafter, a second power supply voltage) is supplied. Here, the second power supply voltage is lower than a high-potential voltage (hereinafter, a first power supply voltage), which is supplied to a first voltage line VL1.

The first transistor T1 controls a current flowing from the first voltage line VL1, to which the first power supply voltage is supplied, to the LED "EL" in accordance with the difference in voltage between the gate electrode and the source electrode of the first transistor T1. For example, the first transistor T1 may be a transistor for driving the LED "EL". The gate electrode of the first transistor T1 may be connected to the source electrode of the second transistor T2, the source electrode of the first transistor T1 may be connected to the first electrode of the LED "EL", and the drain electrode of the first transistor T1 may be connected to the first voltage line VL1, to which the first power supply voltage is supplied.

The second transistor T2 is turned on by a scan signal from a scan line SL to connect a data line DTL to the gate electrode of the first transistor T1. The gate electrode of the second transistor T2 may be connected to the scan line SL, the source electrode of the second transistor T2 may be connected to the gate electrode of the first transistor T1, and the drain electrode of the second transistor T2 may be connected to the data line DTL.

The third transistor T3 is turned on by the scan signal from the scan line SL to connect an initialization voltage line VIL to a first end of the LED "EL". The gate electrode of the third transistor T3 may be connected to the scan line SL, the drain electrode of the third transistor T3 may be connected to the initialization voltage line VIL, and the source electrode of the third transistor T3 may be connected to the first end of the LED "EL" or the source electrode of the first transistor T1.

The source electrodes and the drain electrodes of the first, second, and third transistors T1, T2, and T3 are not limited to the above descriptions. The first, second, and third transistors T1, T2, and T3 may be formed as thin-film transistors (TFTs). FIG. 3 illustrates that the first, second, and third transistors T1, T2, and T3 are formed as N-type metal-oxide semiconductor field-effect transistors (MOSFETs), but the disclosure is not limited thereto. That is, alternatively, the first, second, and third transistors T1, T2, and T3 may all be formed as P-type MOSFETs. Yet alternatively, some of the first, second, and third transistors T1, T2, and T3 may be formed as N-type MOSFETS, and the other transistor(s) may be formed as P-type MOSFETs.

The storage capacitor Cst is formed between the gate electrode and the source electrode of the first transistor T1. The storage capacitor Cst stores a differential voltage corresponding to the difference in voltage between the gate electrode and the source electrode of the first transistor T1.

In the embodiment of FIG. 3, the gate electrodes of the second and third transistors T2 and T3 may be connected to the same scan line. Accordingly, the second and third transistors T2 and T3 may be turned on by a scan signal from the same scan line, but the disclosure is not limited thereto.

Referring to FIG. 4, the gate electrodes of the second and third transistors T2 and T3 may be connected to different scan lines, i.e., first and second scan lines SL1 and SL2. For example, the gate electrode of the second transistor T2 may be electrically connected to the first scan line SL1, and the gate electrode of the third transistor T3 may be electrically connected to the second scan line SL2. The second and third transistors T2 and T3 may be turned on at the same time by scan signals from different scan lines.

The structure of a pixel PX of the display device 10 will hereinafter be described.

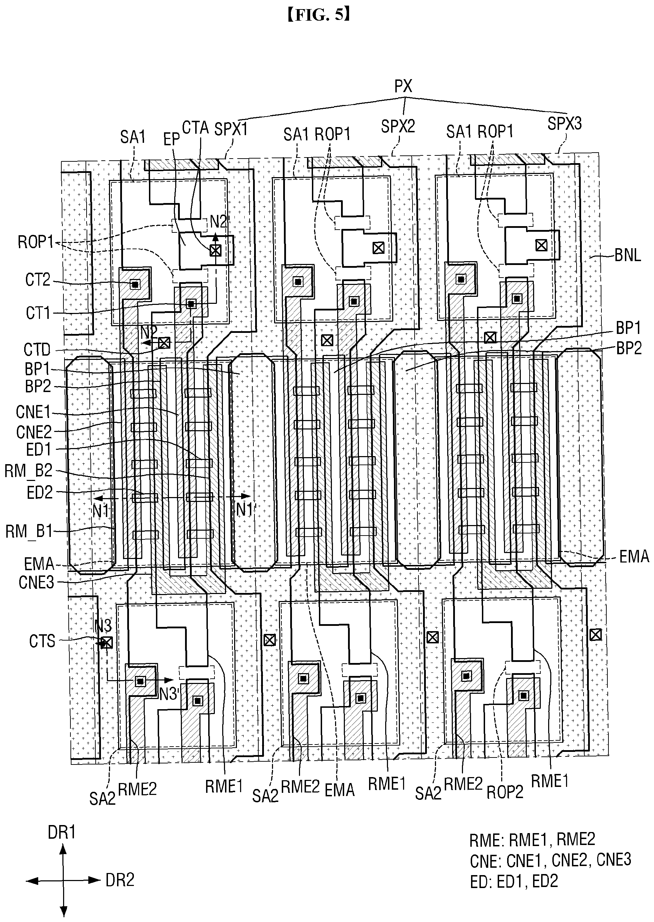

FIG. 5 is a plan view of a pixel of the display device of FIG. 1.

FIG. 5 illustrates the layout of electrodes RME, partitions (BP1 and BP2), a bank layer BNL, a plurality of light-emitting elements ED, and connecting electrodes CNE in a pixel PX of the display device 10.

Referring to FIG. 5, the pixel PX may include a plurality of subpixels SPXn. For example, the pixel PX may include first, second, and third subpixels SPX1, SPX2, and SPX3. The first subpixel SPX1 may emit light of a first color, the second subpixel SPX2 may emit light of a second color, and the third subpixel SPX3 may emit light of a third color. For example, the first, second, and third colors may be blue, green, and red, respectively, but the disclosure is not limited thereto. Alternatively, the first, second, and third subpixels SPX1, SPX2, and SPX3 may all emit light of the same color. For example, the first, second, and third subpixels SPX1, SPX2, and SPX3 may all emit blue light. The pixel PX is illustrated as including three subpixels SPXn, but the disclosure is not limited thereto. That is, the pixel PX may include more than three subpixels SPXn.

Each of the subpixels SPXn may include an emission area EMA and a non-emission area. The emission area EMA may be an area that emits light of a particular wavelength band due to the presence of light-emitting elements ED therein. The non-emission area may be an area that is not reached by light emitted by the light-emitting elements ED and does not output light due to the absence of light-emitting elements therein.

The emission area EMA may include a region where an array of light-emitting elements ED is disposed and a region around the array of light-emitting elements ED that outputs light emitted by the array of light-emitting elements ED. For example, the emission area EMA may also include a region that outputs light emitted by the array of light-emitting elements ED and then reflected or refracted by other members. A plurality of light-emitting elements ED may be disposed in each of the subpixels SPXn to form an emission area EMA including a region where the light-emitting elements ED are disposed and the surroundings of the region where the light-emitting elements ED are disposed.

The emission areas EMA of the subpixels SPXn are illustrated as having the same size, but the disclosure is not limited thereto. Alternatively, the emission areas EMA of the subpixels SPXn may have different sizes depending on the color or wavelength band of light emitted from light-emitting elements ED disposed in their respective subpixels SPXn.

Each of the subpixels SPXn may further include subareas (SA1 and SA2), which are disposed in the non-emission area. The subareas (SA1 and SA2) may include a first subarea SA1, which is disposed on a first side, in the first direction DR1, of the emission area EMA, for example, on the upper side of the emission area EMA, and a second subarea SA2, which is disposed on a second side, in the first direction DR1, of the emission area EMA, for example, on the lower side of the emission area EMA. Emission areas EMA and subareas (SA1 and SA2) may be alternately arranged along the first direction DR1, depending on the layout of pixels PX and subpixels SPXn, and each first or second subarea SA1 or SA2 may be disposed between two different emission areas EMA spaced apart from each other in the first direction DR1. For example, a plurality of emission areas EMA may be repeatedly arranged along the first direction DR1 with a first or second subarea SA1 or SA2 interposed therebetween. A plurality of emission areas EMA, first subareas SA1, and second subareas SA2 may be repeatedly arranged along the second direction DR2, but the disclosure is not limited thereto. The first subareas SA1 and the second subareas SA2 may be areas defined by the layout of wire connecting electrodes EP and electrodes RME that will be described later. That is, emission areas EMA and subareas (SA1 and SA2) may have a different layout from that illustrated in FIG. 5.

The first subareas SA1 and the second subareas SA2 may be areas that are shared by every two adjacent subpixels SPXn in the first direction DR1. For example, the second subareas SA2 may be shared by the subpixels SPXn of FIG. 5 and neighboring subpixels SPXn (not illustrated) adjacent to the subpixels SPXn of FIG. 5 in the first direction DR1. In the subpixels SPXn of FIG. 5, the first subareas SA1 may be disposed on the upper sides of the emission areas EMA, and in the neighboring subpixels SPXn, the second subareas SA2 may be disposed on the upper sides of the emission areas EMA.

As no light-emitting elements ED are disposed in the subareas (SA1 and SA2) of each of the subpixels SPXn, the subareas (SA1 and SA2) do not emit light, but parts of the electrodes RME may be disposed in the subareas (SA1 and SA2). Sets of electrodes RME from different subpixels SPXn may be separated from one another in separation parts (ROP1 and ROP2) of the subareas (SA1 and SA2) of one of the different subpixels SPXn.

The display device 10 may include, in each of the subpixels SPXn of FIG. 5, a plurality of electrodes RME1 and RME2, partitions (BP1 and BP2), a bank layer BNL, light-emitting elements ED, and connecting electrodes CNE1, CNE2, and CNE3.

The partitions (BP1 and BP2) may be disposed in the emission area EMA of each of the subpixels SPXn. The partitions (BP1 and BP2) may generally extend in the first direction DR1 and may be spaced apart from one another in the second direction DR2.

For example, the partitions (BP1 and BP2) may include a first partition BP1 and second partitions BP2, which are disposed in the emission area EMA of each of the subpixels SPXn to be spaced apart from one another in the second direction DR2. The first partition BP1 may be disposed in the middle of the emission area EMA, and the second partitions BP2 may be disposed to be spaced apart from the first partition BP1 with the first partition BP1 interposed therebetween. The first partition BP1 and the second partitions BP2 may be alternately arranged along the second direction DR2, in the form of island patterns, in the display area DPA. A plurality of light-emitting elements ED may be disposed between the first partition BP1 and the second partitions BP2.

The second partitions BP2 may have a larger width than the first partition BP1 in the second direction DR2. The first partition BP1 may be disposed in the emission area EMA of one subpixel SPXn, but each of the second partitions BP2 may be disposed over the emission areas of two adjacent subpixels SPXn in the second direction DR2. Each of the second partitions BP2 may be disposed along the boundary between two adjacent subpixels SPXn in the second direction DR2 and may overlap with the bank layer BNL. However, the disclosure is not limited to this. Alternatively, the first partition BP1 and the second partitions BP2 may all have the same width.

The partitions (BP1 and BP2) may have the same length in the first direction DR1, and the length, in the first direction DR1, of the partitions (BP1 and BP2) may be greater than the length, in the first direction DR1, of the emission area EMA of each of the subpixels SPXn. The partitions (BP1 and BP2) may overlap with parts of the bank layer BNL extending in the second direction DR2, but the disclosure is not limited thereto. Alternatively, the partitions (BP1 and BP2) may be integrally formed with the bank layer BNL or may be spaced apart from the parts of the bank layer BNL extending in the second direction DR2. In this case, the length, in the first direction DR1, of the partitions (BP1 and BP2) may be the same as, or less than, the length, in the first direction DR1, of the emission area EMA of each of the subpixels SPXn, surrounded by the bank layer BNL.

Each of the subpixels SPXn is illustrated as including one first partition BP1 and two second partitions BP2, but the disclosure is not limited thereto. The number and the shape of partitions (BP1 and BP2) in each of the subpixels SPXn may vary depending on the number and the layout of electrodes RME in each of the subpixels SPXn.

The electrodes RME1 and RME2 may be disposed in each of the subpixels SPXn, extending in one direction. The electrodes RME1 and RME2 may be disposed in the emission area EMA and the subareas (SA1 and SA2) of each of the subpixels SPXn, extending in the first direction DR1, and may be spaced apart from one another in the second direction DR2. The electrodes RME1 and RME2 may be electrically connected to the light-emitting elements ED that will be described later, but the disclosure is not limited thereto. Alternatively, the electrodes RME may not be electrically connected to the light-emitting elements ED.

The display device 10 may include, in each of the subpixels SPXn, a first electrode RME1, which is disposed in the middle of one subpixel SPXn, and second electrodes RME2, which are each disposed over two different subpixels SPXn. The first electrode RME1 and the second electrodes RME2 may generally extend in the first direction DR1 and may have different shapes in the emission area EMA of each of the subpixels SPXn. The first electrode RME1 may be disposed near the center of each of the subpixels SPXn, over the emission area EMA and the subareas (SA1 and SA2) of each of the subpixels SPXn. The second electrodes RME2 may be spaced apart from the first electrode RME1 in the second direction DR2, in the emission area EMA of each of the subpixels SPXn, and may be disposed over multiple subpixels SPXn. The first electrode RME1 and the second electrodes RME2 may generally extend in the first direction DR1, but may have different lengths in the first direction DR1 and different shapes in the emission area EMA of each of the subpixels SPXn.

The first electrode RME1 may be disposed in the middle of each of the subpixels SPXn, and part of the first electrode RME1 in the emission area EMA of each of the subpixels SPXn may be disposed on the first partition BP1. The first electrode RME1 may extend in the first direction DR1 from the first subarea SA1 to the second subarea SA2 of each of the subpixels SPXn. The first electrode RME1 may have a shape whose width in the second direction DR2 varies from one location to another location, and at least part of the first electrode RME1 that overlaps with the first partition BP1 in the emission area EMA of each of the subpixels SPXn may have a larger width than the first partition BP1.

Each of the second electrodes RME2 may include a part extending in the first direction DR1 and parts branched off of the part extending in the first direction DR1, in the emission area EMA of each of the subpixels SPXn. Each of the second electrodes RME2 may include electrode stems RM_S, which extend in the first direction DR1, and electrode branches (RM_B1 and RM_B2), which branch off of one of the electrode stems RM_S, are bent in the second direction DR2, and extend back in the first direction DR1. The electrode stems RM_S may be disposed on one side, in the second direction DR2, of the subareas (SA1 and SA2) to overlap with part of the bank layer BNL extending in the first direction DR1. The electrode branches (RM_B1 and RM_B2) may branch off of one of the electrode stems RM_S, which are disposed on part of the bank layer BNL extending in the first direction DR1, and may be bent toward both sides, in the second direction DR2, of the corresponding electrode stem RM_S. Then, the electrode branches (RM_B1 and RM_B2) may extend in the first direction DR1 across the emission areas EMA of two adjacent subpixels SPXn, may be bent, and may thus be connected to the other electrode stem RM_S. For example, the electrode branches (RM_B1 and RM_B2) may branch off of the electrode stem RM_S on the upper side of the emission area EMA of one subpixel SPXn and may be connected to the electrode stem RM_S on the lower side of the emission area EMA of the corresponding subpixel SPXn.

The second electrodes RME2 may include a first electrode branch RM_B1, which is disposed on the left side of the first electrode RME1, and a second electrode branch RM_B2, which is disposed on the right side of the first electrode RME1. First and second electrode branches RM_B1 and RM_B2 of one second electrode RME2 may be disposed over the emission areas EMA of two adjacent subpixels SPXn in the second direction DR2, and first and second electrode branches RM_B1 and RM_B2 of two different second electrodes RME2 may be disposed in one subpixel SPXn. A first electrode branch RM_B1 of one second electrode RME2 may be disposed on the left side of one first electrode RME1, and a second electrode branch RM_B2 of another second electrode RME2 may be disposed on the right side of the corresponding first electrode RME1.

The electrode branches (RM_B1 and RM_B2) may overlap with sides of one second partition BP2. In each of the subpixels SPXn, the first electrode branch RM_B1 may partially overlap with the second partition BP2 on the left side of the first partition BP1, and the second electrode branch RM_B2 may partially overlap with the second partition BP2 on the right side of the first partition BP1. In each of the subpixels SPXn, both sides of the first electrode RME1 may be spaced apart from, and face, first and second electrode branches RM_B1 and RM_B2 of two different second electrodes RME2, and the distance between the first electrode RME1 and the first and second electrode branches RM_B1 and RM_B2 may be less than the distance between the first partition BP1 and the second partitions BP2.

The width, in the second direction DR2, of the first electrode RME1 of each of the subpixels SPXn may be greater than the widths, in the second direction DR2, of the electrode stems RM_S and the electrode branches (RM_B1 and RM_B2) of each of the second electrodes RME2 of each of the subpixels SPXn. In each of the subpixels SPXn, the first electrode RME1 may have a larger width than the first partition BP1 and may overlap with both sides of the first partition BP1, but the second electrodes RME2 may have a relatively small width so that each of the electrode branches (RM_B1 and RM_B2) may overlap with only one side of their respective second partitions BP2.

In each of the subpixels SPXn, the first electrode RME1 may continue to extend from a first separation part ROP1 of the first subarea SA1 to a second separation part ROP2 of the second subarea SA2, and the second electrodes RME2 may not be disconnected in the subareas (SA1 and SA2). One second electrode RME2 may include a plurality of electrode stems RM_S and first and second electrode branches RM_B1 and RM_B2, may extend in the first direction DR1, and may have a shape that branches off near the emission area EMA of a subpixel SPXn. In each of the subpixels SPXn, the first electrode RME1 may be disposed between the separation parts (ROP1 and ROP2) of different subareas (SA1 and SA2) to extend across the emission area EMA.

The display device 10 may include a wire connecting electrode EP in the first subarea SA1 of each of the subpixels SPXn. In the second subarea SA2 of each of the subpixels SPXn, the wire connecting electrode EP may not be disposed, and the first electrodes RME1 of two adjacent subpixels SPXn in the first direction DR1 may be spaced apart from each other. In each of the subpixels SPXn of the pixel PX of FIG. 5, the first subarea SA1 where the wire connecting electrode EP may be disposed on the upper side of the emission area EMA, and the second subarea SA2 may be disposed on the lower side of the emission area EMA. On the contrary, in each of the subpixels SPXn of a neighboring pixel PX, in the first direction DR1, of the pixel PX of FIG. 5, the first subarea SA1 may be disposed on the lower side of the emission area EMA, and the second subarea SA2 may be disposed on the upper side of the emission area EMA.

In the first subarea SA1 of each of the subpixels SPXn, the first electrode RME1 may be spaced apart from the wire connecting electrode EP by a first separation part ROP1. In the first subarea SA1 of each of the subpixels SPXn, two first separation parts ROP1 may be disposed, and the wire connecting electrode EP may be spaced apart from the first electrode RME1 by the lower first separation part ROP1 and from the first electrode RME1 of another subpixel SPXn by the upper first separation part ROP1. In the second subarea SA2 of each of the subpixels SPXn, one second separation part ROP2 may be disposed, and two different first electrodes RME1 may be spaced apart from each other in the first direction DR1 by the second separation part ROP2.

Each of the subpixels SPXn is illustrated as having one first electrode RME1 and two different second electrodes RME2, but the disclosure is not limited thereto. That is, the number of electrodes RME in each of the subpixels SPXn may vary depending on the layout and the shape of the electrodes RME.

The bank layer BNL may be disposed to surround each of the subpixels SPXn and the emission area EMA and the subareas (SA1 and SA2) of each of the subpixels SPXn. The bank layer BNL may be disposed between every two adjacent subpixels SPXn in the first or second direction DR1 or DR2 and between the emission area EMA and the subareas (SA1 and SA2) of every two adjacent subpixels SPXn in the first or second direction DR1 or DR2. Each of the subpixels SPXn and the emission area EMA and the subareas (SA1 and SA2) of each of the subpixels SPXn may be areas defined by the layout of the bank layer BNL. The distances between the emission areas EMA, the first subareas SA1, and the second subareas SA2 of multiple subpixels SPXn may vary depending on the width of the bank layer BNL.

The light-emitting elements ED may be disposed in the emission area EMA of each of the subpixels SPXn. The light-emitting elements ED may be disposed between the partitions (BP1 and BP2) and may be spaced apart from one another in the first or second direction DR1 or DR2. For example, the light-emitting elements ED may extend in one direction, and both end portions of each of the light-emitting elements ED may be disposed on different electrodes RME. The length of the light-emitting elements ED may be greater than the distance, in the second direction DR2, of the electrodes RME. The light-emitting elements ED may be arranged in a direction perpendicular to the direction in which the electrodes RME extend, i.e., in a direction perpendicular to the first direction DR1, but the disclosure is not limited thereto. The direction in which the light-emitting elements ED extend may be the second direction DR2 or a direction inclined from the second direction DR2.

The light-emitting elements ED may include first light-emitting elements ED1, which are disposed on the first electrode RME1 and one of the second electrodes RME2 of each of the subpixels SPXn, and second light-emitting elements ED2, which are disposed on the first electrode RME1 and on the other second electrode RME2 of each of the subpixels SPXn. For example, in the first subpixel SPX1, the first light-emitting elements ED1 may be disposed on the first electrode RME1 and the second electrode branch RM_B2 of one of the second electrodes RME2, and the second light-emitting elements ED2 may be disposed on the first electrode RME1 and the first electrode branch RM_B1 of the other second electrode RME2. In the first subpixel SPX1, the first light-emitting elements ED1 may be disposed on the right side of the first electrode RME1, and the second light-emitting elements ED2 may be disposed on the left side of the first electrode RME1. The first light-emitting elements ED1 and the second light-emitting elements ED2 may each be disposed on first and second electrodes RME1 and RME2, but the second electrode RME2 where the first light-emitting elements ED1 are disposed may differ from the second electrode RME2 where the second light-emitting elements ED2 are disposed.

The connecting electrodes CNE may be disposed on the electrodes RME and the partitions (BP1 and BP2) of each of the subpixels SPXn. The connecting electrodes CNE may extend in one direction and may be spaced apart from one another. In each of the subpixels SPXn, the connecting electrodes CNE may be in contact with the light-emitting elements ED and may be electrically connected to the conductive layers therebelow.

The connecting electrodes CNE may include first, second, and third connecting electrodes CNE1, CNE2, and CNE3, which are disposed in each of the subpixels SPXn.

In each of the subpixels SPXn, the first connecting electrode CNE1 may be disposed on the first electrode RME1, extending in the first direction DR1. In each of the subpixels SPXn, the first connecting electrode CNE1 may be disposed to overlap with the first partition BP1 and the first electrode RME1 and may extend in the first direction DR1 from the emission area EMA and may thus be disposed even in the first subarea SA1 on the upper side of the emission area EMA. In each of the subpixels SPXn, the first connecting electrode CNE1 may be in contact with the first electrode RME1 through a first contact hole CT1, which is formed on the first electrode RME1, in the first subarea SA1.

In each of the subpixels SPXn, the second connecting electrode CNE2 may be spaced apart from the first connecting electrode CNE1 in the second direction DR2 and may be disposed on the second electrode RME2, extending in the first direction DR1. In each of the subpixels SPXn, the second connecting electrode CNE2 may be disposed to overlap with the second partition BP2 and the second electrode branch RM_B2 of one of the second electrodes RME2 and may extend in the second direction DR2 from the emission area EMA to be disposed even in the first subarea SA1, on the upper side of the emission area EMA. In each of the subpixels SPXn, the second connecting electrode CNE2 may be in contact with one of the second electrodes RME2 through a second contact hole CT2, which is formed on one of the second electrodes RME2, in the first subarea SA1.

The third connecting electrode CNE3 may include first and second extensions CN_E1 and CN_E2 and a first connector CN_B1, which connects first and second extensions CN_E1 and CN_E2. In each of the subpixels SPXn, the first extension CN_E1 may face the first connecting electrode CNE1, in the emission area EMA, and may be disposed on the second electrodes RME2. For example, in the first subpixel SPX1, the first extension CN_E1 may be disposed on the second electrode branch RM_B2 of one of the second electrodes RME2, the second extension CN_E2 may face the second connecting electrode CNE2 and may be disposed on the first electrode RME1, in the emission area EMA, and the first connector CN_B1 may extend in the second direction DR2 on the bank layer BNL, on the lower side of the emission area EMA, to connect the first and second extensions CN_E1 and CN_E2. The third connecting electrode CNE3 may be disposed in the emission area EMA of each of the subpixels SPXn and on the bank layer BNL, but may not be directly connected to the electrodes RME. In each of the subpixels SPXn, the second electrode RME2 below the first extension CN_E1 may be electrically connected to the second voltage line VL2, and the second power supply voltage applied to the corresponding second electrode RME2 may not be transmitted to the third connecting electrode CNE3.

As will be described later, both end portions of each of the light-emitting elements ED may be defined, and the light-emitting elements ED may be connected in series through the connecting electrodes CNE that both end portions of each of the light-emitting elements ED are in contact with. As the display device 10 includes a relatively large number of light-emitting elements ED in each of the subpixels SPXn and can configure serial connections between the light-emitting elements ED, the amount of light emitted per unit area can be increased.

The display device 10 may further include first, second, and third insulating layers PAS1, PAS2, and PAS3, which are disposed between the electrodes RME1 and RME2, the light-emitting elements ED, and the connecting electrodes CNE1, CNE2 and CNE3, in each of the subpixels SPXn. In each of the subpixels SPXn, the electrodes RME1 and RME2, the light-emitting elements ED, and the connecting electrodes CNE1, CNE2 and CNE3 may be disposed to overlap with one another, but only partially due to the presence of the first, second, and third insulating layers PAS1, PAS2, and PAS3.

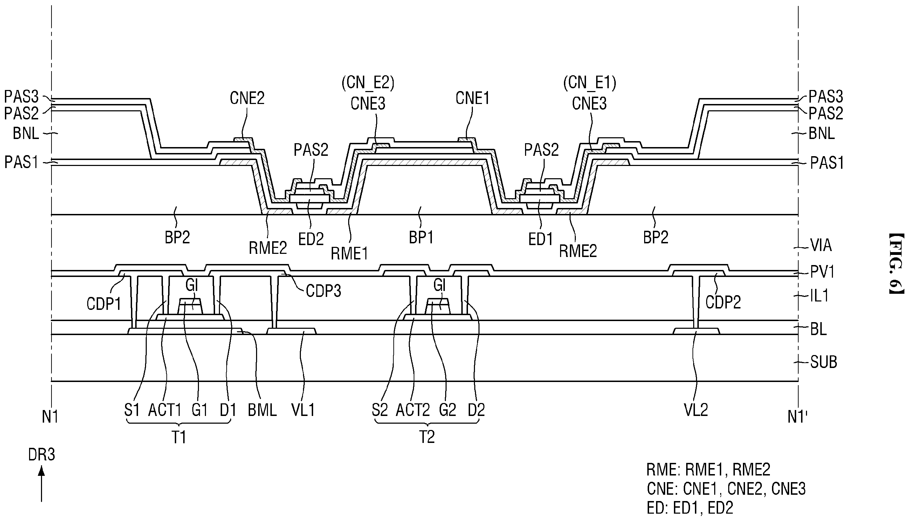

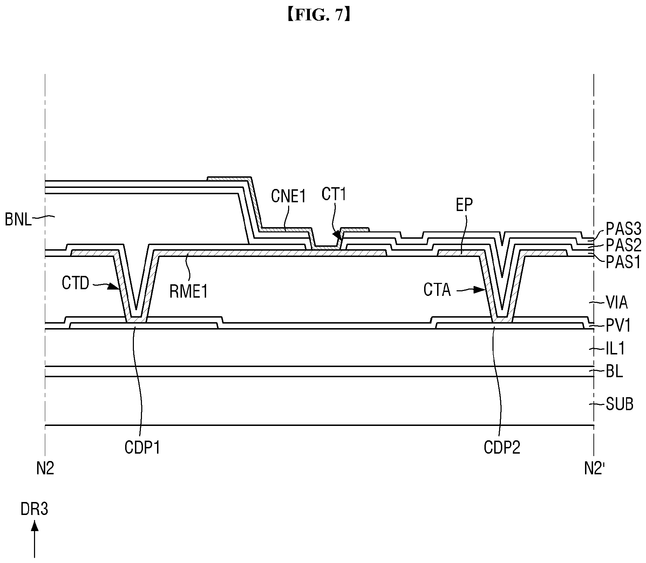

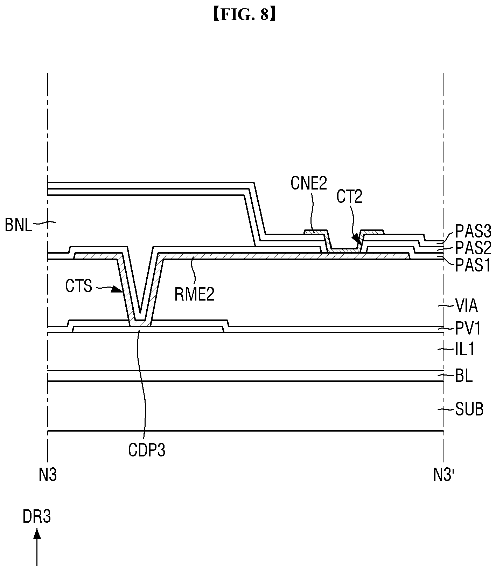

FIG. 6 is a cross-sectional view taken along line N1-N1' of FIG. 5. FIG. 7 is a cross-sectional view taken along line N2-N2' of FIG. 5. FIG. 8 is a cross-sectional view taken along line N3-N3' of FIG. 5.

FIG. 6 illustrates a cross-sectional view taken across both end portions of each of light-emitting elements ED disposed on different electrodes RME. FIGS. 7 and 8 illustrate cross-sectional views taken across first, second, and/or third electrode contact holes CTD, CTS, and/or CTA and across a first contact hole CT1 and/or a second contact hole CT2.

Referring to FIGS. 6 through 8 and further to FIG. 5, the display device 10 may include, in each of the subpixels SPXn, for example, in the first subpixel SPX1, a first substrate SUB and a semiconductor layer, a plurality of conductive layers, and a plurality of insulating layers, which are disposed on the first substrate SUB. The display device 10 may further include a plurality of electrodes RME, light-emitting elements ED, and connecting electrodes CNE.

The first substrate SUB may be an insulating substrate. The first substrate SUB may be formed of an insulating material such as glass, quartz, or a polymer resin. The first substrate SUB may be a rigid substrate or may be a flexible substrate that is bendable, foldable, or rollable. The first substrate SUB may include a display area DPA and a non-display area NDA, which surrounds the display area DPA, and the display area DPA may include the emission area EMA and the first and second subareas SA1 and SA2, which are parts of the non-emission area.

The first conductive layer may include the lower metal layer BML and the first and second voltage lines VL1 and VL2. The lower metal layer BML is disposed to overlap with an active layer ACT1 of a first transistor T1. The lower metal layer BML may prevent light from being incident upon the first active layer ACT1 of the first transistor T1 or may be electrically connected to the first active layer ACT1 to stabilize the electrical characteristics of the first transistor T1. The lower metal layer BML may not be provided.

The high-potential voltage (or the first power supply voltage), which is to be delivered to the first electrode RME1, may be applied to the first voltage line VL1, and the low-potential voltage (or the second power supply voltage), which is to be delivered to the second electrode RME2, may be applied to the second voltage line VL2. The first voltage line VL1 may be electrically connected to the first transistor T1 through a conductive pattern of a second conductive layer (e.g., a third conductive pattern CDP3). The second voltage line VL2 may be electrically connected to one of the second electrodes RME2 through a conductive pattern of the third conductive layer (e.g., a second conductive pattern CDP2).

The first and second voltage lines VL1 and VL2 are illustrated as being disposed in the first conductive layer, but the disclosure is not limited thereto. Alternatively, the first and second voltage lines VL1 and VL2 may be disposed in the third conductive layer to be directly and electrically connected to the first transistor T1 and one of the second electrodes RME2.

A buffer layer BL may be disposed on the first conductive layer and the first substrate SUB. The buffer layer BL may be formed on the first substrate SUB to protect the transistors of each of the subpixels SPXn from moisture that may penetrate through the first substrate SUB, which is vulnerable to moisture, and may perform a surface planarization function.

The semiconductor layer is disposed on the buffer layer BL. The semiconductor layer may include the first active layer ACT1 of the first transistor T1 and a second active layer ACT2 of a second transistor T2. The first and second active layers ACT1 and ACT2 may be disposed to partially overlap with first and second gate electrodes G1 and G2, respectively, of a second conductive layer that will be described later.

The semiconductor layer may include polycrystalline silicon, monocrystalline silicon, or an oxide semiconductor. Alternatively, the semiconductor layer may include polycrystalline silicon. The oxide semiconductor may contain indium (In). For example, the oxide semiconductor may be at least one of indium tin oxide (ITO), indium zinc oxide (IZO), indium gallium oxide (IGO), indium zin tin oxide (IZTO), indium gallium tin oxide (IGTO), or indium gallium zinc tin oxide (IGZTO).

The first subpixel SPX1 is illustrated as including one first transistor T1 and one second transistor T2, but the disclosure is not limited thereto. That is, the display device 10 may include, in each of the subpixels SPXn, more than one first transistor T1 and more than one second transistor T2.

The first gate insulating layer GI is disposed on the semiconductor layer. The first gate insulating layer GI may function as a gate insulating layer for first and second transistors T1 and T2 of the second conductive layer. The first gate insulating layer GI may be patterned together with first and second gate electrodes G1 and G2 of the second conductive layer and may thus be placed in part between the second conductive layer and the first and second active layers ACT1 and ACT2 of the semiconductor layer, but the disclosure is not limited thereto. Alternatively, the first gate insulating layer GI may be disposed on the entire surface of the buffer layer BL, covering the semiconductor layer.

The second conductive layer is disposed on the first gate insulating layer GI. The second conductive layer may include the first and second gate electrodes G1 and G2 of the first and second transistors T1 and T2. The first gate electrode G1 may be disposed to overlap with the channel region of the first active layer ACT1 in a thickness direction, i.e., in the third direction DR3, and the second gate electrode G2 may be disposed to overlap with the channel region of the second active layer ACT2 in the thickness direction, i.e., in the third direction DR3. Although not specifically illustrated, the second conductive layer may further include a first electrode of a storage capacitor.

The first interlayer insulating layer IL1 is disposed on the second conductive layer. The first interlayer insulating layer IL1 may function as an insulating film between the second conductive layer and layers disposed on the second conductive layer and may protect the second conductive layer.

The third conductive layer is disposed on the first interlayer insulating layer IL1. The third conductive layer may include the first, second, and third conductive patterns CDP1, CDP2, and CDP3, a first source electrode S1 and a first drain electrode D1 of the first transistor T1, and a second source electrode S2 and a second drain electrode D2 of the second transistor T2. Some of the first, second, and third conductive patterns CDP1, CDP2, and CDP3 may electrically connect different conductive layers or different semiconductor layers and may function as the source and drain electrodes of each of the first and second transistors T1 and T2.

The first conductive pattern CDP1 may be in contact with the first active layer ACT1 of the first transistor T1. The first conductive pattern CDP1 may be in contact with the lower metal layer BML through a contact hole penetrating the first interlayer insulating layer IL1 and the buffer layer BL. The first conductive pattern CDP1 may function as the first source electrode S1 of the first transistor T1. The first conductive pattern CDP1 may be electrically connected to the first electrode RME1 or the first connecting electrode CNE1. The first transistor T1 may transmit the first power supply voltage from the first voltage line VL1 to the first electrode RME1 or the first connecting electrode CNE1.

The second conductive pattern CDP2 may be in contact with the second voltage line VL2 through a contact hole penetrating the first interlayer insulating layer IL1 and the buffer layer BL. The second voltage line VL2 may transmit the second power supply voltage to the second connecting electrode CNE2 through the second conductive pattern CDP2.

The third conductive pattern CDP3 may be in contact with the first voltage line VL1 through a contact hole penetrating the first interlayer insulating layer IL1 and the buffer layer BL. The third conductive pattern CDP3 may be in contact with the first active layer ACT1 of the first transistor T1 through a contact hole penetrating the first interlayer insulating layer IL1. The third conductive pattern CDP3 may electrically connect the first transistor T1 and may function as the first drain electrode D1 of the first transistor T1.

The second source electrode S2 and the second drain electrode D2 may be in contact with the second active layer ACT2 of the second transistor T2 through contact holes penetrating the first interlayer insulating layer IL1.

The first passivation layer PV1 is disposed on the third conductive layer. The first passivation layer PV1 may function as an insulating film between the third conductive layer and other layers and protect the third conductive layer.

Each of the buffer layer BL, the first gate insulating layer GI, the first interlayer insulating layer IL1, and the first passivation layer PV1 may consist of a plurality of inorganic layers that are alternately stacked. For example, each of the buffer layer BL, the first gate insulating layer GI, the first interlayer insulating layer IL1, and the first passivation layer PV1 may be formed as a double- or multilayer in which inorganic layers of at least one of silicon oxide (SiOₓ), silicon nitride (SiNₓ), and silicon oxynitride (SiOₓN_{y}) are alternately stacked, but the disclosure is not limited thereto. In another example, each of the buffer layer BL, the first gate insulating layer GI, the first interlayer insulating layer IL1, and the first passivation layer PV1 may be formed as a single inorganic layer including SiOₓ, SiNₓ, or SiOₓN_{y}. In some embodiments, the first interlayer insulating layer IL1 may be formed of an organic insulating material such as polyimide.

A via layer VIA is disposed on the third conductive layer, in the display area DPA. The via layer VIA may include an organic insulating material such as, for example, polyimide, and may perform a surface planarization function by compensating for any height differences generated by the underlying conductive layers. In some embodiments, the via layer VIA may not be provided.

The display device 10 may include, as a display element layer on the via layer VIA, the partitions (BP1 and BP2), the electrodes RME1 and RME2, the bank layer BNL, the light-emitting elements ED1 and ED2, and the connecting electrodes CNE1, CNE2, and CNE3. The display device 10 may include the first, second, and third insulating layers PAS1, PAS2, and PAS3.

The partitions (BP1 and BP2) may be disposed on the via layer VIA. For example, the partitions (BP1 and BP2) may be disposed directly on the via layer VIA and may protrude at least in part from the top surface of the via layer VIA. As already mentioned above, the first partition BP1 and the second partitions BP2 may be spaced apart from one another, and the first partition BP1 may be disposed between the second partitions BP2. The partitions (BP1 and BP2) may have inclined sides or curved or bent sides with a predetermined curvature, and light emitted from the light-emitting elements ED1 and ED2 may be reflected by the electrodes RME1 and RME2 on the partitions (BP1 and BP2) to be emitted in an upward direction from the via layer VIA. Alternatively, the partitions (BP1 and BP2) may have a curved or bent shape with a predetermined curvature, for example, a semicircular or semielliptical shape, in a cross-sectional view. The partitions (BP1 and BP2) may include an inorganic insulating material such as polyimide, but the disclosure is not limited thereto.

The electrodes RME1 and RME2 may be disposed on the partitions (BP1 and BP2) and the via layer VIA. For example, parts of the electrodes RME1 and RME2 may be disposed on at least inclined sides of the partitions (BP1 and BP2). The first electrode RME1 may be disposed to cover the first partition BP1, and the second electrodes RME2, particularly, the first and second electrode branches RM_B1 and RM_B2, may be disposed to cover sides of the second partitions BP2. The width of the first electrode RME1 may be greater than the width of the first partition BP1, and the width of the first and second electrode branches RM_B1 and RM_B2 may be less than the width of the second partitions BP2. The distance between the electrodes RME may be less than the distance between the partitions (BP1 and BP2). At least parts of the electrodes RME may be disposed directly on the via layer VIA to fall on the same plane.

The light-emitting elements ED, which are disposed between the partitions (BP1 and BP2), emit light through both end portions thereof, and the emitted light may travel toward the electrodes RME on the partitions (BP1 and BP2). Parts of the electrodes RME that are disposed on the partitions (BP1 and BP2) may have a structure capable of reflecting light emitted from the light-emitting elements ED. The electrodes RME may be disposed to cover at least sides of the partitions (BP1 and BP2) to reflect light emitted from the light-emitting elements ED.

The first electrode RME1 and the second electrodes RME2 may be in direct contact with the third conductive layer through the first and second contact holes CTD and CTS, which are disposed to overlap with the bank layer BNL. For example, the first electrode contact hole CTD may be formed in an area where the first electrode RME1 and the bank layer BNL overlap with each other, and the second contact hole CTS may be formed in an area where the second electrode RME2 and the bank layer BNL overlap with each other. The first electrode RME1 may be in contact with the first conductive pattern CDP1 through the first electrode contact hole CTD, which penetrates the via layer VIA and the first passivation layer PV1, and may be electrically connected to the first transistor T1, and the second electrode RME2 may be in contact with the second conductive pattern CDP2 through the second electrode contact hole CTS, which penetrates the via layer VIA and the first passivation layer PV1, and may be electrically connected to the second voltage line VL2.

The wire connecting electrode EP may be disposed in the first subarea SA1 and may be in direct contact with the third conductive layer through the third electrode contact hole CTA. For example, the wire connecting electrode EP may be in contact with the third conductive pattern CDP3 through the third electrode contact hole CTA, which penetrates the via layer VIA and the first passivation layer PV1. The wire connecting electrode EP may be electrically connected to the first voltage line VL1 through the third conductive pattern CDP3.

During the fabrication of the display device 10, the first electrode RME1 may be formed as being connected to the wire connecting electrode EP, and electrical signals for arranging the light-emitting elements ED may be applied from the first voltage line VL1 to the first electrode RME1 through the wire connecting electrode EP. Then, the electrical signals may be applied to the first and second voltage lines VL1 and VL2 and may be transmitted to the first electrode RME1 and the second electrodes RME2.

The first and second electrode contact holes CTD and CTS may have a different relative layout from the third electrode contact hole CTA. The first electrode contact hole CTD may be disposed in each of the first and second subareas SA1 and SA2, and the second electrode contact hole CTS may be formed to overlap with part of the bank layer BNL on one side, in the second direction DR2, of each of the first and second areas SA1 and SA2. On the contrary, the third electrode contact hole CTA may be disposed only in the first subarea SA1. The locations of the second and third electrode contact holes CTS and CTA may be determined to expose the top surfaces of different voltage lines. The first separation parts ROP1 may be disposed in the first subarea SA1, on the upper and lower sides of the wire connecting electrode EP. On the contrary, the second separation part ROP2 may be disposed in the second subarea SA2, between two different first electrodes RME1. Two first separation parts ROP1 may be formed in the first subarea SA1, and one second separation part ROP2 may be formed in the second subarea SA2.

The electrodes RME may include a conductive material with high reflectance. For example, the electrodes RME may include a metal such as silver (Ag), Cu, or aluminium (Al), an alloy including Al, nickel (Ni), or lanthanum (La), or a stack of a layer of such alloy and a layer of a metal such as titanium (Ti), molybdenum (Mo), or niobium (Nb). In some embodiments, the electrodes RME may be formed as double- or multilayers in which at least one layer of an alloy containing Al and at least one layer of a metal such as Ti, Mo, or Nb are stacked.

However, the disclosure is not limited to this. Alternatively, the electrodes RME may further include a transparent conductive material. For example, the electrodes RME may include a material such as ITO, IZO, or IZTO. In some embodiments, the electrodes RME may have a structure in which at least one layer of a transparent conductive material and at least one layer of a metal with high reflectance are stacked or may be formed as single-layer films including the transparent conductive material and the metal with high reflectance. For example, the electrodes RME may have a stack structure such as ITO/Ag/ITO/, ITO/Ag/IZO, or ITO/Ag/IZTO/IZO. The electrodes RME may be electrically connected to the light-emitting elements ED and may reflect some of the light emitted from the light-emitting elements ED, in an upward direction from the first substrate SUB.

The first insulating layer PAS1 may be disposed in the entire display area DPA, on the via layer VIA and the electrodes RME. The first insulating layer PAS1 may protect the electrodes RME and insulate the electrodes RME from each other. As the first insulating layer PAS1 is disposed to cover the electrodes RME, before the formation of the bank layer BNL, the first insulating layer PAS1 can prevent the electrodes RME from being damaged during the formation of the bank layer BNL. Also, the first insulating layer PAS1 can prevent the light-emitting elements ED from being in direct contact with, and damaged by, other members.

The first insulating layer PAS1 may be formed to be recessed in part between the electrodes RME, which are spaced apart from each other in the second direction DR2. The light-emitting elements ED may be disposed on the top surface of a recessed part of the first insulating layer PAS1, and space may be formed between the light-emitting elements ED and the first insulating layer PAS1.

The first insulating layer PAS1 may include separation openings, which correspond to the separation parts (ROP1 and ROP2), and contact holes (CT1 and CT2). The first insulating layer PAS1 may be disposed on the entire surface of the via layer VIA, but may expose parts of the underlying layers in areas where the separation openings and the contact holes (CT1 and CT2) are formed.

The separation openings, which are formed in the first insulating layer PAS1 to correspond to the separation parts (ROP1 and ROP2) of the subareas (SA1 and SA2), may expose the via layer VIA. The disconnection of the first electrode RME1, which is previously connected to first electrodes RME1 of neighboring subpixels SPXn, in the first direction DR1, of the first subpixel SPX1, may be performed in the separation openings. Specifically, a first electrode RME1 may originally be formed as being connected throughout multiple subpixels SPXn adjacent to one another in the first direction DR1 and may be separated from multiple individual first electrodes RME and multiple wire connecting electrodes EP of the corresponding multiple subpixels SPXn by etching parts of the original first electrode RME1, exposed by the separation openings. The separation openings of the first insulating layer PAS1 may be disposed to correspond to the separation parts ROP1 and ROP2), which are disposed between two different first electrodes RME1 or between a first electrode RME1 and a wire connecting electrode EP.

The contact holes (CT1 and CT2) of the first insulating layer PAS1 may be disposed to overlap with different electrodes RME in each of the first and second subareas SA1 and SA2. For example, the contact holes (CT1 and CT2) may include first contact holes CT1, which are disposed to overlap with the first electrode RME1, and second contact holes CT2, which are disposed to overlap with the second electrode RME2. The first contact holes CT1 and the second contact holes CT2 may be disposed in the first and second subareas SA1 and SA2. The first contact hole CT1 disposed in the first subarea SA1 may be spaced apart from the first separation part ROP1 on the lower side of the wire connecting electrode EP and may be disposed on the first electrode RME1. The first contact hole CT1 disposed in the second subarea SA2 may be spaced apart from the second separation part ROP2 and may be disposed on a first electrode RME1 of a neighboring subpixel SPXn, in the first direction DR1, of the first subpixel SPX1. The second contact holes CT2 may be disposed on parts of the electrode stem RM_S of one of the second electrodes RME that protrude into the first and second subareas SA1 and SA2.

The first contact holes CT1 and the second contact holes CT2 may penetrate the first insulating layer PAS1 and may thus expose parts of the top surfaces of the first electrode RME1 and one of the second electrodes RME2. The first contact holes CT1 and the second contact holes CT2 may further penetrate some of insulating layers disposed on the first insulating layer PAS1. Parts of the electrodes RME exposed by the contact holes (CT1 and CT2) may be in contact with the connecting electrodes CNE.

The bank layer BNL may be disposed on the first insulating layer PAS1. The bank layer BNL may include parts extending in the first direction DR1 and parts extending in the second direction DR2 and may surround each of the subpixels SPXn. The bank layer BNL may surround the emission areas EMA and the subareas (SA1 and SA2) of the subpixels SPXn to define and separate the emission areas EMA and the subareas (SA1 and SA2). The bank layer BNL may also be disposed along the boundaries of the display area DPA to define and separate the display area DPA and the non-display area NDA. The parts of the bank layer BNL extending in the first direction DR1 may separate the emission areas EMA and the subareas (SA1 and SA2), and the parts of the bank layer BNL extending in the second direction DR2 may separate the subpixels SPXn from other neighboring subpixels SPXn. The parts of the bank layer BNL extending in the second direction DR2 may be disposed on the second partitions BP2 of each of the subpixels SPXn.

The bank layer BNL, like the partitions (BP1 and BP2), may have a predetermined height. In some embodiments, the height of the bank layer BNL may be greater than the height of the partitions (BP1 and BP2), and the thickness of the bank layer BNL may be the same as, or greater than, the thickness of the partitions (BP1 and BP2). The bank layer BNL may prevent ink from spilling between neighboring subpixels SPXn in an inkjet printing process during the fabrication of the display device 10. The bank layer BNL, like the partitions (BP1 and BP2), may include an organic insulating material such as polyimide, but the disclosure is not limited thereto. Alternatively, the bank layer BNL may include a different material from the partitions (BP1 and BP2).

The light-emitting elements ED may be disposed in the emission area EMA of each of the subpixels SPXn. The light-emitting elements ED may be disposed on the first insulating layer PAS1, between the partitions (BP1 and BP2). The light-emitting elements ED may be arranged such that the direction in which the light-emitting elements ED extend may be parallel to the top surface of the first substrate SUB. As will be described later, each of the light-emitting elements ED may include multiple semiconductor layers that are arranged in the direction in which the light-emitting elements ED extend, and the multiple semiconductor layers may be sequentially arranged in a direction parallel to the top surface of the first substrate SUB. However, the disclosure is not limited to this. Alternatively, the multiple semiconductor layers may be arranged in a direction perpendicular to the first substrate SUB.

The light-emitting elements ED of one subpixel SPXn may emit light of a different wavelength range from the light-emitting elements ED of another subpixel SPXn, depending on the materials of the semiconductor layers of each of the light-emitting elements ED of each subpixel SPXn, but the disclosure is not limited thereto. Alternatively, the semiconductor layers of each of the light-emitting elements ED of one subpixel SPXn may include the same materials as the semiconductor layers of each of the light-emitting elements ED of another subpixel SPXn, so that the light-emitting elements ED of one subpixel SPXn may emit light of the same color as the light-emitting elements ED of another subpixel SPXn.

The light-emitting elements ED may be disposed on different electrodes RME, between different partitions (BP1 and BP2). The first light-emitting elements ED1 may be disposed between the first partition BP1 and one of the second partitions BP2 such that both end portions of each of the first light-emitting elements ED1 may be placed on the first electrode RME1 and the second electrode branch RM_B2 of one of the second electrodes RME2. The second light-emitting elements ED2 may be disposed between the first partition BP1 and the other second partition BP2 such that both end portions of each of the second light-emitting elements ED2 may be placed on the first electrode RME1 and the first electrode branch RM_B1 of the other second electrode RME2. The first light-emitting elements ED1 may be disposed in the emission area EMA, on the right side of the first partition BP1, and the second light-emitting elements ED2 may be disposed in the emission area EMA, on the left side of the first partition BP1.

The light-emitting elements ED may be in contact with the connecting electrodes CNE to be electrically connected to the electrode RME and the conductive layers below the via layer VIA and may emit light of a particular wavelength range in response to electrical signals being applied thereto.

The second insulating layer PAS2 may be disposed on the light-emitting elements ED, the first insulating layer PAS1, and the bank layer BNL. The second insulating layer PAS2 may include patter parts, which extend in the first direction DR1 between the partitions (BP1 and BP2) and are disposed on the light-emitting elements ED. The pattern parts may be disposed to surround the outer surfaces of each of the light-emitting elements ED, but not to cover both sides or both end portions of each of the light-emitting elements ED. The pattern parts may form linear or island patterns in each of the subpixels SPXn in a plan view. The pattern parts of the second insulating layer PAS2 may protect the light-emitting elements ED and may fix the light-emitting elements ED during the fabrication of the display device 10. The second insulating layer PAS2 may be disposed to fill the space between the first insulating layer PAS1 and the light-emitting elements ED. Parts of the second insulating layer PAS2 may be disposed on the bank layer BNL and in the first and second subareas SA1 and SA2.

The second insulating layer PAS2 may include the separation openings, which are formed to correspond to the separation parts (ROP1 and ROP2), and the contact holes (CT1 and CT2). The second insulating layer PAS2 may be disposed on the entire surface of the first insulating layer PAS1 and may expose parts of the underlying layer(s) in areas where the separation openings and the contact holes (CT1 and CT2) are formed. The separation openings and the contact holes (CT1 and CT2) are as already described above with regard to the first insulating layer PAS1.

The connecting electrodes CNE may be disposed on the electrodes RME and the partitions (BP1 and BP2). The connecting electrodes CNE may be classified into connecting electrodes CNE of a first connecting electrode layer, which is between the second and third insulating layers PAS2 and PAS3, and connecting electrodes CNE of a second connecting electrode layer, which is on the third insulating layer PAS3. The third connecting electrode CNE3 may be a connecting electrode CNE of the first connecting electrode layer, and the first and second connecting electrodes CNE1 and CNE2 may be connecting electrodes CNE of the second connecting electrode layer.

The first connecting electrode CNE1 may be disposed on the first electrode RME1 and the first partition BP1. The second connecting electrode CNE2 may be disposed on one of the second electrodes RME2 and one of the second partitions BP2. The third connecting electrode CNE3 may be disposed on the first electrode RME1, the other second electrode RME2, the other second partition BP2, and the first partition BP1. The layout of the connecting electrodes CNE is as already described above with reference to FIG. 5.

The first, second, and third connecting electrodes CNE1, CNE2, and CNE3 may be disposed on the second insulating layer PAS2 and may be in contact with the light-emitting elements ED. The first connecting electrode CNE1 may be in contact with first end portions of the first light-emitting elements ED1. The second connecting electrode CNE2 may be in contact with second end portions of the second light-emitting elements ED2. The first extension portion CN_E1 of the third connecting electrode CNE3 may be in contact with the second end portions of the first light-emitting elements ED1, and the second extension CN_E2 may be in contact with the first end portions of the second light-emitting elements ED2.

The first and second connecting electrodes CNE1 and CNE2 may be disposed in the emission area EMA and the subareas (SA1 and SA2) and may be in direct contact with the electrodes RME through the contact holes (CT1 and CT2), which are formed in the subareas (SA1 and SA2). The first connecting electrode CNE1 may be in contact with the first electrode RME1 through the first contact holes CT1, which are formed in the subareas (SA1 and SA2) and penetrate the first, second, and third insulating layers PAS1, PAS2, and PAS3. The second connecting electrodes CNE2 may be in contact with the second electrodes RME2 through the second contact holes CT2, which are formed in the subareas (SA1 and SA2) and penetrate the first, second, and third insulating layers PAS1, PAS2, and PAS3. On the contrary, the third connecting electrode CNE3 may not be in contact with the electrodes RME.

The first connecting electrode CNE1 may be electrically connected to the first transistor T1 through the first electrode RME1 and may thus receive the first power supply voltage, and the second connecting electrode CNE2 may be electrically connected to the second voltage line VL2 through the second electrodes RME and may thus receive the second power supply voltage. The light-emitting elements ED may emit light in response to the power supply voltages applied thereto through the first and second connecting electrodes CNE1 and CNE2.

The first and second connecting electrodes CNE1 and CNE2 may be first-type connecting electrodes directly connected to the third conductive layer, and the third connecting electrode CNE3 may be a second-type connecting electrode not connected to the electrodes RME. The third connecting electrode CNE3 may not be connected to the electrodes RME, but may be in contact with the light-emitting elements ED to form electrical connections for the light-emitting elements ED together with the other connecting electrodes CNE.

However, the disclosure is not limited to this. In some embodiments, some of the connecting electrodes CNE may be directly connected to the third conductive layer. For example, the first and second connecting electrodes CNE1 and CNE2, which are first-type connecting electrodes, may be directly connected to the third conductive layer, but may not be electrically connected to the electrodes RME, and the third connecting electrode CNE3, which is a second-type connecting electrode, may not be electrically connected to the electrodes RME, but may be connected only to the light-emitting elements ED.

The connecting electrodes CNE may include a conductive material. For example, the connecting electrodes CNE may include ITO, IZO, IZTO, or Al. For example, the connecting electrodes CNE may include a transparent conductive material so that light emitted by the light-emitting elements ED may be output through the connecting electrodes CNE.

The third insulating layer PAS3 is disposed on the second insulating layer PAS2 together with the connecting electrodes CNE of a second connecting electrode layer. The third insulating layer PAS3 may be disposed on the entire surface of the second insulating layer PAS2 to cover the third connecting electrode CNE3, and the first and second connecting electrodes CNE1 and CNE2 may be disposed on the third insulating layer PAS3. The third insulating layer PAS3 may be disposed on the entire surface of the via layer VIA except for an area where the third connecting electrode CNE3 is disposed. The third insulating layer PAS3 may insulate the connecting electrodes CNE of the first connecting electrode layer and the connecting electrodes CNE of the second connecting electrode layer not to be in direct contact with one another.

The third insulating layer PAS3 may include a plurality of contact holes, i.e., the first contact holes CT1 and the second contact holes CT2. The third insulating layer PAS3 may be disposed on the entire surface of the second insulating layer PAS2 and may expose parts of the underlying layers through the first contact holes CT1 and the second contact holes CT2. The first contact holes CT1 and the second contact holes CT2 may penetrate not only the first and second insulating layers PAS1 and PAS2, but also the third insulating layer PAS3. The first contact holes CT1 and the second contact holes CT2 may expose parts of the top surfaces of the electrodes RME.

The first, second, and third insulating layers PAS1, PAS2, and PAS3 may include an inorganic insulating material or an organic insulating material. For example, the first, second, and third insulating layers PAS1, PAS2, and PAS3 may all include an inorganic insulating material. In another example, the first and third insulating layers PAS1 and PAS3 may include an inorganic insulating material, and the second insulating layer PAS2 may include an organic insulating material. At least one of the first, second, and third insulating layers PAS1, PAS2, and PAS3 may have a structure in which multiple insulating layers are alternately or repeatedly stacked. The first, second, and third insulating layers PAS1, PAS2, and PAS3 may include one of SiOₓ, SiNₓ, and SiOₓN_{y}. The first, second, and third insulating layers PAS1, PAS2, and PAS3 may include the same material, some of the first, second, and third insulating layers PAS1, PAS2, and PAS3 may include the same material, or the first, second, and third insulating layers PAS1, PAS2, and PAS3 may include different materials.

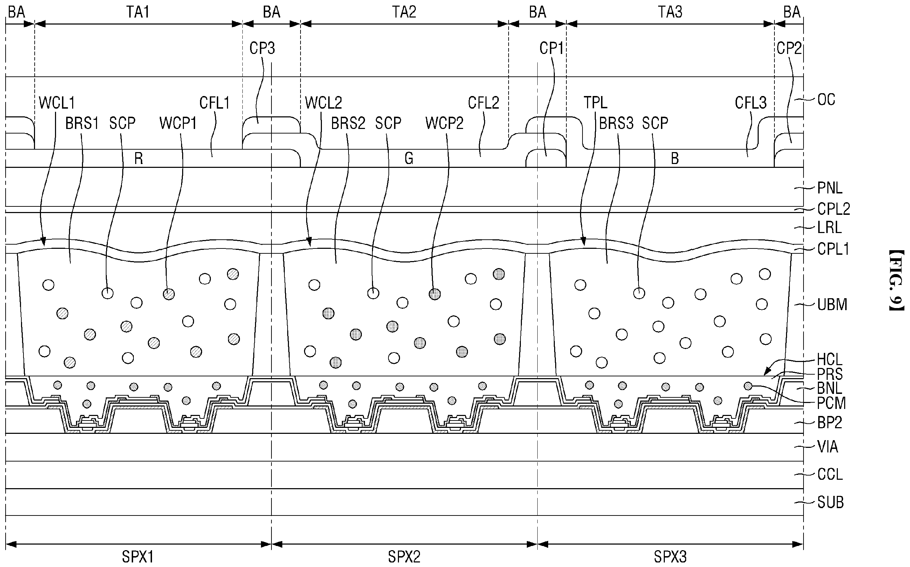

The display device 10 may further include, in each of the subpixels SPXn, a thermal control layer HCL (see FIG. 9), a color control layer (TPL, WCL1, and WCL2) (see FIG. 9), and color filter layers (CFL1, CFL2, and CFL3) (see FIG. 9). Light emitted from the light-emitting elements ED may be output through the color control layer (TPL, WCL1, and WCL2) and the color filter layers (CFL1, CFL2, and CFL3), and the color of the light may vary from one subpixel SPXn to another subpixel SPXn even if light-emitting elements ED of the same type are disposed in each of the subpixels SPXn. Also, heat generated when the light-emitting elements ED emit light may be absorbed by the thermal control layer HCL, and the thermal control layer HCL may prevent the heat from being transmitted to the color control layer (TPL, WCL1, and WCL2).

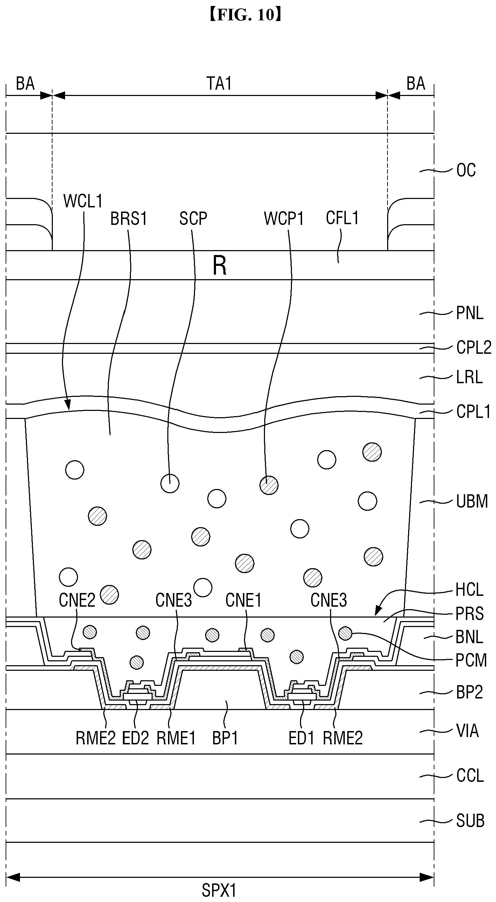

FIG. 9 is a cross-sectional view illustrating a color control layer and a thermal control layer in a pixel of the display device of FIG. 1. FIG. 10 is a cross-sectional view illustrating a first wavelength conversion layer and a thermal control layer in a first subpixel of FIG. 9.

FIGS. 9 and 10 are cross-sectional views illustrating the layout of the color control layer (TPL, WCL1, and WCL2), the color filter layers (CFL1, CFL2, and CFL3), and the thermal control layer HCL in a pixel PX of the display device 10. Partitions (BP1 and BP2), electrodes RME1 and RME2, the bank layer BNL, light-emitting elements ED, and connecting electrodes CNE1 and CNE2 disposed in each of a plurality of subpixels SPXn of the pixel PX are as already described above with reference to FIGS. 5 through 8.

Referring to FIGS. 9 and 10, the display device 10 may include, in each of the subpixels SPXn, light-emitting elements ED, which are disposed on the first substrate SUB, and the thermal control layer HCL, the color control layer (TPL, WCL1, and WCL2), and the color filter layers (CFL1, CFL2, and CFL3), which are disposed on the light-emitting elements ED. The display device 10 may further include a plurality of layers, which are disposed between the color control layer (TPL, WCL1, and WCL2) and the color filter layers (CFL1, CFL2, and CFL3) or on the color filter layers (CFL1, CFL2, and CFL3).

An upper bank layer UBM, the thermal control layer HCL, the color control layer (TPL, WCL1, and WCL2), color patterns (CP1, CP2, and CP3), and the color filter layers (CFL1, CFL2, and CFL3) may be disposed on the third insulating layer PAS3. First and second capping layers CPL1 and CPL2, a low refractive index layer LRL, and a planarization layer PNL may be disposed between the color control layer (TPL, WCL1, and WCL2) and the color filter layers (CFL1, CFL2, and CFL3), and an overcoat layer OC may be disposed on the color filter layers (CFL1, CFL2, and CFL3).

The pixel PX may include a plurality of light-transmitting areas TA, in which the color filter layers (CFL1, CFL2, and CFL3) are disposed so that light is emitted, and a light-blocking area BA, which is between the light-transmitting areas TA and do not emit light. The light-transmitting areas TA may be disposed to correspond to parts of emission areas EMA of the subpixels SPXn, and the light-blocking area BA may account for areas other than the light-transmitting areas TA. For example, the light-blocking area BA may surround the light-transmitting areas TA.

The upper bank layer UBM may be disposed on the third insulating layer PAS3 to overlap with the bank layer BNL. The upper bank layer UBM may include parts extending in the first direction DR1 and parts extending in the second direction DR2. The upper bank layer UBM may surround the emission areas EMA or areas where the light-emitting elements ED are disposed. The upper bank layer UBM may form areas where the color control layer (TPL, WCL1, and WCL2) is disposed.

The thermal control layer HCL may be disposed on the third insulating layer PAS3 and the first and second connecting electrodes CNE1 and CNE2, which are included in the second connecting electrode layer. The thermal control layer HCL may be disposed on the third insulating layer PAS3 to correspond to areas defined by the bank layer BNL. For example, the thermal control layer HCL may be disposed in the emission areas EMA surrounded by the bank layer BNL. Although not specifically illustrated, the thermal control layer HCL may also be disposed in subareas (SA1 and SA2) of each of the subpixels SPXn. Parts of the thermal control layer HCL disposed in different subpixels SPXn may be separated from one another by the bank layer BNL, but the disclosure is not limited thereto. Alternatively, a single thermal control layer HCL may be formed throughout multiple subpixels SPXn and may be disposed on the entire surface of the display area DPA, and this will be described later.

The thermal control layer HCL may include a resin layer PRS and phase change particles PCM, which are dispersed in the resin layer PRS. The phase change particles PCM may include a material capable of absorbing or releasing heat and thereby having its phase changed, and the thermal control layer HCL may absorb heat generated therearound. The thermal control layer HCL may be disposed on the third insulating layer PAS3 to cover the light-emitting elements ED and may absorb heat generated by the light-emitting elements ED. The thermal control layer HCL may reduce the transfer of heat generated by the light-emitting elements ED to the color control layer (TPL, WCL1, and WCL2).

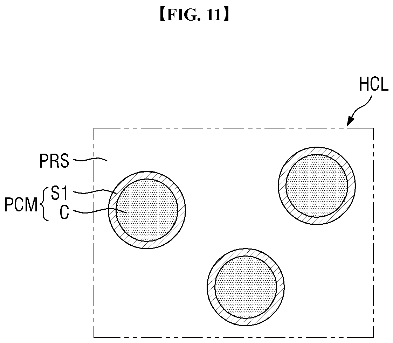

FIG. 11 illustrates phase change particles in the thermal control layer of the display device of FIG. 1.

Referring to FIG. 11, the phase change particles PCM of the thermal control layer HCL may have a core-shell structure. Each of the phase change particles PCM may include a core C, which includes a phase change material, and a first shell S1, which surrounds the core C. The core C may include a material having a large amount of latent and thereby having its phase changed depending on the absorption or release of heat. For example, the core C may include a material such as an alkane having 10 or more carbon atoms, polyethylene glycol (PEG), or a polyethylene glycol derivative, an aluminium (Al)-silicon (Si) alloy, or an inorganic hydrate. The core may include an alkane having 12 carbon atoms, i.e., dodecane (C₁₂H₂₆), an alkane having 22 carbon atoms, i.e., docosane (C₂₂H₄₆), or an Al-Si alloy.

C₁₂H₂₆ and C₂₂H₄₆ have a latent heat of about 210 kJ/kg and about 230 kJ/kg, respectively, and C₂₂H₄₆ has a phase change temperature of about 44 °C. An Al-Si alloy has a latent heat of about 180 kJ/kg and has a phase change temperature of about 577 °C. The alkane having 10 or more carbon atoms is not particularly limited to C₁₂H₂₆ or C₂₂H₄₆. Any alkane other than C₁₂H₂₆ or C₂₂H₄₆ may be used as the material of the core C as long as it has a similar latent heat to C₁₂H₂₆ or C₂₂H₄₆ and has a phase change property.

The core C of the phase change particle PCM may change phase due to heat generated during the driving of the display device 10. Heat generated when the light-emitting elements ED emit light may be absorbed by the phase change particles PCM of the thermal control layer HCL and may thus be prevented from spreading.

The first shell S1 of the phase change particle PCM may include a relatively rigid material to be able to respond to a volume change resulting from a phase change of the core C. For example, the first shell S1 may include a material such as polystyrene (PS), polymethylmethacrylate (PMMA), aluminium oxide (Al₂O₃), or PMMA-silica. The first shell S1 may include a material capable of maintaining the shape of the phase change particles PCM even when a volume change occurs in response to the core C absorbing or releasing heat, and may prevent the volatilization and leakage of the core C.

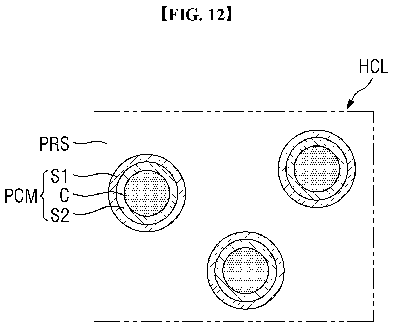

FIG. 12 illustrates phase change particles in a thermal control layer of a display device according to another embodiment of the disclosure.

Referring to FIG. 12, each of phase change particles PCM of a thermal control layer HCL may include a first shell S1 and a core C and may further include a second shell S2, which is disposed between the first shell S1 and the core C. The second shell S2 may be disposed to surround the core C, and the first shell S1 may be disposed to surround the second shell S2. The second shell S2 may include a thermal conductive material to be able to easily absorb and release heat. For example, the second shell S2 may include a conductive polymer such as graphite, carbon black, or poly(3,4-ethylenedioxythiophene)-poly(styrenesulfonate) (PEDOT:PSS). As each of the phase change particles PCM further includes the second shell S2, the thermal control layer HCL may be able to easily control heat generated by light-emitting elements ED.

Heat generated during the driving of the light-emitting elements ED may cause a decrease in the luminance of the display device 10. If the heat is transmitted to neighboring light-emitting elements ED or to the color control layer (TPL, WCL1, and WCL2), the luminance of the display device 10 may be lowered due to the deterioration of the light-emitting elements ED and the color control layer (TPL, WCL1, and WCL2), and this may lead to a decrease in the life of the display device 10. To prevent this, the display device 10 may include the thermal control layer HCL, which covers the light-emitting elements ED and is disposed between the light-emitting elements ED and the color control layer (TPL, WCL1, and WCL2). The thermal control layer HCL may absorb heat generated by the light-emitting elements ED and may thus minimize the transfer of heat. As most of the heat generated during the driving of the display device 10 is absorbed by the thermal control layer HCL, the deterioration of the light-emitting elements ED and the color control layer (TPL, WCL1, and WCL2) can be prevented, and the life of the display device 10 can be lengthened.

The thermal control layer HCL may be formed by inkjet printing, and the phase change particles PCM of the thermal control layer HCL may have a small particle size and may be dispersed in the resin layer PRS. The phase change particles PCM may have a sufficiently small diameter in consideration of the nozzle diameter of an inkjet printing device. The phase change particles PCM may have a diameter of about 1 µm or less, about 0.5 µm or less, or about 0.2 µm or less.

The resin layer PRS of the thermal control layer HCL may include an organic material having a sufficient viscosity to have the phase change particles PCM dispersed therein and to be able to be ejected through an inkjet printing device. Also, the resin layer PRS may include a transparent material to transmit light emitted by the light-emitting elements ED therethrough. The resin layer PRS may include an epoxy resin, an acrylic resin, a cardo resin, or an imide resin.

The color control layer (TPL, WCL1, and WCL2) may be disposed directly on the thermal control layer HCL and may be positioned in areas surrounded by the upper bank layer UBM. The color control layer (TPL, WCL1, and WCL2) may be disposed to be in direct contact with inner sides of the upper bank layer UBM. The color control layer (TPL, WCL1, and WCL2) may be disposed in the light-transmitting areas TA surrounded by the upper bank layer UBM and may form island patterns in the display area DPA. FIG. 9 illustrates that the color control layer (TPL, WCL1, and WCL2) is disposed to fill areas surrounded by the bank layer BNL and the upper bank layer UBM, but the disclosure is not limited thereto. Alternatively, the color control layer (TPL, WCL1, and WCL2) may extend in one direction across multiple subpixels SPXn to form linear patterns.

In an embodiment where the light-emitting elements ED emit third-color light, i.e., blue light, the color control layer (TPL, WCL1, and WCL2) may include wavelength conversion layers (WCL1 and WCL2) and a light-transmitting layer TPL. The wavelength conversion layers (WCL1 and WCL2) may include first and second wavelength conversion layers WCL1 and WCL2, which are disposed in first and second subpixels SPX1 and SPX2, respectively, of the pixel PX. The light-transmitting layer TPL may be disposed in a third subpixel SPX3 of the pixel PX. The first wavelength conversion layer WCL1 may be disposed in a first light-transmitting area TA1 of the first subpixel SPX1, and the second wavelength conversion layer WCL2 may be disposed in a second light-transmitting area TA2 of the second subpixel SPXn. The light-transmitting layer TPL may be disposed in a third light-transmitting area TA3 of the third subpixel SPX3.

The first wavelength conversion layer WCL1 may include a first base resin BRS1 and a first wavelength conversion material WCP1, which is disposed in the first base resin BRS1. The second wavelength conversion layer WCL2 may include a second base resin BRS2 and a second wavelength conversion material WCP2, which is disposed in the second base resin BRS2. The first and second wavelength conversion layers WCL1 and WCL2 may wavelength-convert third-color light incident from the light-emitting elements ED, i.e., blue light, and may transmit the wavelength-converted light therethrough. Each of the first and second wavelength conversion layers WCL1 and WCL2 may further include a scatterer SCP, which is included in the first or second base resin BRS1 or BRS2, and the scatterer SCP may increase the wavelength conversion efficiency of the first and second wavelength conversion layers WCL1 and WCL2.

The light-transmitting layer TPL may include a third base resin BRS3 and a scatterer SCP, which is disposed in the third base resin BRS3. The light-transmitting layer TPL may transmit the third-color light incident from the light-emitting elements ED therethrough while maintaining the wavelength of the third-color light. The scatterer SCP of the light-transmitting layer TPL may control the path of light emitted through the light-transmitting layer TPL. The light-transmitting layer TPL may not include a wavelength conversion material.

The scatterers SCP of the first and second wavelength conversion layers WCL1 and WCL2 and the scatterer SCP of the light-transmitting layer TPL may be particles of a metal oxide or particles of an organic material. Here, the metal oxide may be titanium oxide (TiO₂), zirconium oxide (ZrO₂), aluminium oxide (Al₂O₃), indium oxide (In₂O₃), barium sulfate (BaSO₄), zinc oxide (ZnO), or tin oxide (SnO₂), and the organic material may be an acrylic resin or a urethane resin.

The first, second, and third base resins BRS1, BRS2, and BRS3 may include a light-transmitting organic material. For example, the first, second, and third base resins BRS1, BRS2, and BRS3 may include an epoxy resin, an acrylic resin, a cardo resin, or an imide resin. The first, second, and third base resins BRS1, BRS2, and BRS3 may be formed of the same material, but the disclosure is not limited thereto.

The first wavelength conversion material WCP1 may convert third-color light, i.e., blue light, into first-color light, i.e., red light, and the second wavelength conversion material WCP2 may convert blue light into second-color light, i.e., green light. The first and second wavelength conversion materials WCP1 and WCP2 may include quantum dots, quantum rods, or phosphors. The quantum dots may include group IV nanocrystals, group II-VI compound nanocrystals, group III-V compound nanocrystals, group IV-VI nanocrystals, or a combination thereof.

In some embodiments, the color control layer (TPL, WCL1, and WCL2) may be formed by inkjet printing or a photoresist process. The color control layer (TPL, WCL1, and WCL2) may be formed by spraying or applying the materials of the color control layer (TPL, WCL1, and WCL2) into the areas surrounded by the upper bank layer UBM and performing drying, exposure, and development processes. For example, in a case where the color control layer (TPL, WCL1, and WCL2) is formed by inkjet printing, the top surface of the color control layer (TPL, WCL1, and WCL2) may be curved such that the height of the color control layer (TPL, WCL1, and WCL2) may be greater near the upper bank layer UBM than in the middle of the areas surrounded by the upper bank layer UBM. However, the disclosure is not limited to this example. In another example, in a case where the color control layer (TPL, WCL1, and WCL2) is formed by a photoresist process, the top surface of the color control layer (TPL, WCL1, and WCL2) may be flat such that the top surface of part of the color control layer (TPL, WCL1, and WCL2) near the upper bank layer UBM may be parallel to the top surface of the upper bank layer UBM. In yet another example, the top surface of the color control layer (TPL, WCL1, and WCL2) may be greater in the middle of the areas surrounded by the upper bank layer UBM than on the edges of each of the areas surrounded by the upper bank layer UBM.

The first wavelength conversion layer WCL1 may be disposed in the first subpixel SPX1. The first wavelength conversion layer WCL1 may be disposed in the emission area EMA of the first subpixel SPX1, surrounded by the bank layer BNL and the upper bank layer UBM. The second wavelength conversion layer WCL2 may be disposed in the second subpixel SPX2. The second wavelength conversion layer WCL2 may be disposed in the emission area EMA of the second subpixel SPX2, surrounded by the bank layer BNL and the upper bank layer UBM.

The light-transmitting layer TPL may be disposed in the third subpixel SPX3. The light-transmitting layer TPL may be disposed in the emission area EMA of the third subpixel SPX3, surrounded by the bank layer BNL and the upper bank layer UBM.

The light-emitting elements ED, which are disposed in each of the subpixels SPXn, may be disposed to overlap with the color control layer (TPL, WCL1, and WCL2), and light emitted by the light-emitting elements ED may be incident upon the color control layer (TPL, WCL1, and WCL2).

For example, the light-emitting elements ED may all emit the third-color light, i.e., blue light, in each of the subpixels SPXn, and the color of light emitted by the light-emitting elements ED may differ from one subpixel SPXn to another subpixel SPXn. Light emitted by the light-emitting elements ED in the first subpixel SPX1 may be incident upon the first wavelength conversion layer WCL1, light emitted by the light-emitting elements ED in the second subpixel SPX2 may be incident upon the second wavelength conversion layer WCL2, and light emitted by the light-emitting elements ED in the third subpixel SPX3 may be incident upon the light-transmitting layer TPL. The light incident upon the first wavelength conversion layer WCL1 may be converted into red light, the light incident upon the second wavelength conversion layer WCL2 may be converted into green light, and the light incident upon the light-transmitting layer TPL may be transmitted through the light-transmitting layer TPL as blue light without being wavelength-converted. The first, second, and third subpixels SPX1, SPX2, and SPX3 may emit light of different colors depending on the layout of the color control layer (TPL, WCL1, and WCL2), even if they include the same light-emitting elements ED emitting light of the same color.

The thermal control layer HCL may include the resin layer PRS and particles dispersed in the resin layer PRS, i.e., the phase transition particles PCM, and the color control layer (TPL, WCL1, and WCL2) may include the first, second, and third base resins BRS1, BRS2, and BRS3 and particles dispersed in each of the first, second, and third base resins BRS1, BRS2, and BRS3, i.e., the first and second wavelength conversion layers WCL1 and WCL2 and the scatterers SCP. The thermal control layer HCL, which is a layer for controlling heat generated by the light-emitting elements ED, and the color control layer (TPL, WCL1, and WCL2), which is a layer for controlling the color of light emitted by the light-emitting elements ED, may differ in their functions.

The thickness and the layout of the thermal control layer HCL may vary if the thermal control layer HCL can cover the light-emitting elements ED and can contain sufficient phase change particles PCM to control heat generated by the light-emitting elements ED. For example, the thermal control layer HCL may be disposed in the areas surrounded by the bank layer BNL such that the height of the top surface of the thermal control layer HCL may be the same as the height of uppermost parts of the bank layer BNL, the second insulating layer PAS2, and the third insulating layer PAS3, but the disclosure is not limited thereto. Alternatively, the thermal control layer HCL may have a larger thickness than that illustrated, and the top surface of the thermal control layer HCL may be positioned above the bank layer BNL, the second insulating layer PAS2, and the third insulating layer PAS3. Alternatively, the height of the top surface of the thermal control layer HCL may be less than the height of the uppermost parts of the bank layer BNL, the second insulating layer PAS2, and the third insulating layer PAS3.

The color coordinates or the luminance of light emitted by the light-emitting elements ED and then converted by, or transmitted through, the color control layer (TPL, WCL1, and WCL2) may vary depending on the thickness of the color control layer (TPL, WCL1, and WCL2). The color control layer (TPL, WCL1, and WCL2) may have a minimum thickness to achieve a sufficient conversion efficiency for light emitted by the light-emitting elements ED, depending on the materials of the first and second wavelength conversion materials WCP1 and WCP2 and the scatterers SCP. The thickness of the color control layer (TPL, WCL1, and WCL2) may be greater than the thickness of the thermal control layer HCL. The upper bank layer UBM may be disposed on the bank layer BNL and may have a greater thickness than the bank layer BNL. As the color control layer (TPL, WCL1, and WCL2) is disposed in the areas surrounded by the upper bank layer UBM, the color control layer (TPL, WCL1, and WCL2) may be thicker than the thermal control layer HCL, which is disposed in the areas surrounded by the bank layer BNL. The thermal control layer HCL may have a thickness of about 2 µm, and the color control layer (TPL, WCL1, and WCL2) may have a thickness of about 8 µm to about 10 µm. Even if the thermal control layer HCL has a relatively large thickness, the thermal control layer HCL may still be thinner than the color control layer (TPL, WCL1, and WCL2). The display device 10 can effectively control heat generated by the light-emitting elements ED, by controlling the thicknesses of the thermal control layer HCL and the color control layer (TPL, WCL1, and WCL2), and can improve the conversion efficiency for light emitted by the light-emitting elements ED.

As the thermal control layer HCL and the color control layer (TPL, WCL1, and WCL2) have different functions, the resin layer PRS and the first, second, and third base resins BRS1, BRS2, and BRS3 may have different functions. Various transparent materials may be used to form the resin layer PRS as long as they can produce a resin layer PRS having a sufficient viscosity to have the phase change particles PCM dispersed therein and to be able to be ejected through the nozzles of an inkjet printing device and be formed by inkjet printing. On the contrary, the material of the first, second, and third base resins BRS1, BRS2, and BRS3 may be selected not only in consideration of a sufficient viscosity to allow the first, second, and third base resins BRS1, BRS2, and BRS3 to be able to be ejected through nozzles and to have the first and second wavelength conversion materials WCP1 and WCP2 dispersed therein, but also in consideration of the conversion efficiency of light emitted by the light-emitting elements ED. The resin layer PRS and the first, second, and third base resins BRS1, BRS2, and BRS3 may include an epoxy resin, an acrylic resin, a cardo resin, or an imide resin. The resin layer PRS and the first, second, and third base resins BRS1, BRS2, and BRS3 may all include the same material or may include different materials. The materials of the resin layer PRS and the first, second, and third base resins BRS1, BRS2, and BRS3 may be determined based on the material of the phase change particles PCM of the thermal control layer HCL, the performance of an inkjet printing device, and the color coordinates of light emitted by the light-emitting elements ED.

The first capping layer CPL1 may be disposed on the color control layer (TPL, WCL1, and WCL2) and the upper bank layer UBM. The first capping layer CPL1 may prevent the color control layer (TPL, WCL1, and WCL2) from being damaged by, or contaminated with, impurities such as moisture or the air from the outside. The first capping layer CPL1 may include an inorganic insulating material.

The first capping layer CPL1 may be disposed to cover the color control layer (TPL, WCL1, and WCL2), along height differences formed by the color control layer (TPL-WCL1, and WCL2). The color control layer (TPL, WCL1, and WCL2) may be disposed to fill the areas surrounded by the upper bank layer UBM, and the first capping layer CPL1 may be disposed to extend from the top surface of the color control layer (TPL, WCL1, and WCL2) to the top surface of the upper bank layer UBM.

The low-refractive index layer LRL may be disposed on the first capping layer CPL1. The low-refractive index layer LRL, which is an optical layer for recycling light transmitted through the color control layer (TPL, WCL1, and WCL2), may improve the emission efficiency and the color purity of the display device 10. The low-refractive index layer LRL may be formed of an organic material with a low refractive index and may compensate for height differences formed by the color control layer (TPL, WCL1, and WCL2) and the upper bank layer UBM.

The second capping layer CPL2 may be disposed on the low-refractive index layer LRL and may prevent the low-refractive index layer LRL from being damaged by, or contaminated with, impurities such as moisture or the air from the outside. The second capping layer CPL2, like the first capping layer CPL1, may include an inorganic insulating material.

The planarization layer PNL may be disposed on the second capping layer CPL2, in the entire display area DPA and the entire non-display area NDA. The planarization layer PNL may overlap with the color control layer (TPL, WCL1, and WCL2) in the display area DPA. The planarization layer PNL may protect members disposed on the first substrate SUB, including the first and second capping layers CPL1 and CPL2 and the low-refractive index layer LRL, and may partially compensate for height differences formed by the members disposed on the first substrate SUB. The planarization layer PNL may compensate for the height differences formed by the color control layer (TPL, WCL1, and WCL2), the upper bank layer UBM, and the bank layer BNL, in the display area DPA, and as a result, the color filter layers (CFL1, CFL2, and CFL3) may be formed on a flat surface.

The color filter layers (CFL1, CFL2, and CFL3) may be disposed on the planarization layer PNL. The color filter layers (CFL1, CFL2, and CFL3) may be disposed in the light-transmitting areas TA of the subpixels SPXn and may partially extend even into the light-blocking area BA. The color filter layers (CFL1, CFL2, and CFL3) may overlap with one another or the color patterns (CP1, CP2, and CP3), in the light-blocking area BA. Areas where the color filter layers (CFL1, CFL2, and CFL3) do not overlap with one another may be the light-transmitting areas TA, which emit light, and areas where the color filter layers (CFL1, CFL2, and CFL3) overlap with one another or the color patterns (CP1, CP2, and CP3) are disposed may correspond to the light-blocking area BA, which blocks the emission of light.

The color filter layers (CFL1, CFL2, and CFL3) may include first, second, and third color filter layers CFL1, CFL2, and CFL3, which are disposed in the first, second, and third subpixels SPX1, SPX2, and SPX3, respectively. The color filter layers (CFL1, CFL2, and CFL3) may be disposed as island patterns to correspond to the light-transmitting areas TA or the emission areas EMA, but the disclosure is not limited thereto. Alternatively, the color filter layers (CFL1, CFL2, and CFL3) may be disposed across multiple light-transmitting areas TA or multiple emission areas EMA to form linear patterns.

The color filter layers (CFL1, CFL2, and CFL3) may include a colorant such as a pigment or a dye capable of absorbing light of all wavelength bands except for a particular wavelength band. The color filter layers (CFL1, CFL2, and CFL3) may transmit only some of light incident thereupon therethrough. The subpixels SPXn may selectively display only beams of light transmitted through the color filter layers (CFL1, CFL2, and CFL3). The first color filter layer CFL1 may be a red color filter layer, the second color filter layer CFL2 may be a green color filter layer, and the third color filter layer CFL3 may be a blue color filter layer. Light emitted by the light-emitting elements ED may be output from the color filter layers (CFL1, CFL2, and CFL3) through the color control layer (TPL, WCL1, and WCL2).

The color patterns (CP1, CP2, and CP3) may be disposed on the planarization layer PNL or the color filter layers (CFL1, CFL2, and CFL3). The color patterns (CP1, CP2, and CP3) may include the same material as the color filter layers (CFL1, CFL2, and CFL3) and may be disposed in the light-blocking area BA. The color filter layers (CFL1, CFL2, and CFL3) and the color patterns (CP1, CP2, and CP3) of different colors from the color filter layers (CFL1, CFL2, and CFL3) may be stacked in the light-blocking area BA, and the transmission of light may be blocked in areas where the color filter layers (CFL1, CFL2, and CFL3) and the color patterns (CP1, CP2, and CP3) are stacked.

A first color pattern CP1 may include the same material as the first color filter layer CFL1 and may be disposed in the light-blocking area BA. The first color pattern CP1 may be disposed directly on the planarization layer PNL in the light-blocking area BA, but may not be disposed in part of the light-blocking area BA near the first light-transmitting area TA1. The first color pattern CP1 may be disposed between the second and third subpixels SPX2 and SPX3 or between the second and third light-transmitting areas TA2 and TA3. The first color filter layer CFL1 may extend into, and be disposed in, parts of the light-blocking area BA around the first subpixel SPX1.

A second color pattern CP2 may include the same material as the second color filter layer CFL2 and may be disposed in the light-blocking area BA. The second color pattern CP2 may be disposed directly on the planarization layer PNL in the light-blocking area BA, but may not be disposed in part of the light-blocking area BA near the second light-transmitting area TA2. The second color pattern CP2 may be disposed between the third subpixel SPX3 and another first subpixel SPX1 (not illustrated) or between the third light-transmitting area TA3 and another first light-transmitting area TA1 (not illustrated). The second color filter layer CFL2 may extend into, and be disposed in, parts of the light-blocking area BA around the second subpixel SPX2.

Similarly, a third color pattern CP3 may include the same material as the third color filter layer CFL3 and may be disposed in the light-blocking area BA. The third color pattern CP3 may be disposed directly on the second color pattern CP2 or the second color filter layer CFL2, on the planarization layer PNL in the light-blocking area BA, but may not be disposed in part of the light-blocking area BA near the third light-transmitting area TA3. The third color pattern CP3 may be disposed between the first and second subpixels SPX1 and SPX2 or between the first and second light-transmitting areas TA1 and TA2. The third color filter layer CFL3 may extend into, and be disposed in, parts of the light-blocking area BA around the third subpixel SPX3.

Areas where the bank layer BNL and the upper bank layer UBM overlap with each other may become the light-blocking area BA, and in the light-blocking area BA, each of the first, second, and third color patterns CP1, CP2, and CP3 may overlap with at least one of the color filter layers (CFL1, CFL2, and CFL3) including a different colorant therefrom. For example, the first color pattern CP1 may be disposed to overlap with the second and third color filter layers CFL2 and CFL3, the second color pattern CP2 may be disposed to overlap with the third color filter layer CFL3 and another first color filter layer CFL1 (not illustrated), and the third color pattern CP3 may be disposed to overlap with the first and second color filter layers CFL1 and CFL2. As the color patterns (CP1, CP2, and CP3) and the color filer layers (CFL1, CFL2, and CFL3) including different colorants from the color patterns (CP1, CP2, and CP3) overlap with one another in the light-blocking area BA, the transmission of light can be blocked.

The color patterns (CP1, CP2, and CP3) may be stacked on the color filter layers (CFL1, CFL2, and CFL3) including different colorants therefrom, and as a result, the mixing of colors between adjacent subpixels SPXn can be prevented. As the color patterns (CP1, CP2, and CP3) include the same material as the color filter layers (CFL1, CFL2, and CFI3), external light or reflected light transmitted through the light-blocking area BA may have a predetermined wavelength band. The eye color sensibility perceived by the eyes of a user varies depending on the color of light, and blue-wavelength light may be perceived less sensitively than green- and red-wavelength light to the user. As the color patterns (CP1, CP2, and CP3) are disposed in the light-blocking area BA, the transmission of light can be blocked, and at the same time, reflected light can be perceived less sensitively by the user. Also, reflected light from external light can be reduced by absorbing some of the external light.

The overcoat layer OC may be disposed on the color filter layers (CFL1, CFL2, and CFL3) and the color patterns (CP1, CP2, and CP3). The overcoat layer OC may be disposed in the entire display area DPA and may also be disposed in part even in the non-display area NDA. The overcoat layer OC may include an organic insulating material and may protect the members disposed in the display area DPA from the outside.

As the display device 10 includes the color control layer (TPL, WCL1, and WCL2) and the color filter layers (CFL1, CFL2, and CFL3) above the light-emitting elements ED, the light-emitting elements ED may be able to emit light of different colors in different subpixels SPXn, even when they are all of the same type.

The light-emitting elements ED in the first subpixel SPX1 may emit third-color light, i.e., blue light, and the blue light may be incident upon the first wavelength conversion layer WCL1 through the thermal control layer HCL. The resin layer PRS of the thermal control layer HCL and the first base resin BRS1 of the first wavelength conversion layer WCL1 may be formed of a transparent material, and some of the blue light may be incident upon the first capping layer CPL1 through the resin layer PRS and the first base resin BRS1. Specifically, at least some of the blue light may be incident upon the scatterer SCP and the first wavelength conversion material WCP1 in the first base resin BRS1, may be scattered and wavelength-converted, and may be incident upon the first capping layer CPL1 as red light. The light incident upon the first capping layer CPL1 may be incident upon the first color filter layer CFL1 through the low-refractive index layer LRL, the second capping layer CPL2, and the planarization layer PNL, and the first color filter layer CFL1 may block the transmission of other beams of light than red light. Accordingly, red light may be emitted from the first subpixel SPX1.

Similarly, light emitted by the light-emitting elements ED in the second subpixel SPX2 may be emitted as green light through the thermal control layer HCL, the second wavelength conversion layer WCL2, the first capping layer CPL1, the low-refractive index layer LRL, the second capping layer CPL2, the planarization layer PNL, and the second color filter layer CFL2.

The light-emitting elements ED in the third subpixel SPX3 may emit blue light, and the blue light may be incident upon the light-transmitting layer TPL through the thermal control layer HCL. The third base resin BRS3 of the light-transmitting layer TPL may be formed of a transparent material, and some of the blue light may be incident upon the first capping layer CPL1 through the resin layer PRS and the third base resin BRS3. The light incident upon the first capping layer CPL1 may be incident upon the third color filter layer CFL3 through the low-refractive index layer LRL, the second capping layer CPL2, and the planarization layer PNL, and the third color filter layer CFL3 may block the transmission of other beams of light than blue light. Accordingly, blue light may be emitted from the third subpixel SPX3.

As the display device 10 includes the thermal control layer HCL on the light-emitting elements ED, the display device 10 can effectively control heat released from the light-emitting elements ED. The display device 10 can minimize any degradation that may be caused by heat released from the light-emitting elements ED, and the life of the display device 10 can be lengthened.

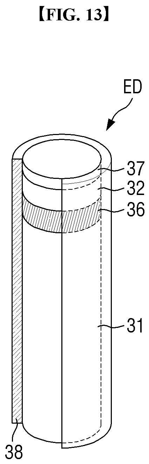

FIG. 13 is a perspective view of a light-emitting element according to an embodiment of the disclosure.

Referring to FIG. 13, a light-emitting element ED may be an LED. Specifically, the light-emitting element ED may be an inorganic LED having a size of several nanometers or micrometers and formed of an inorganic material. If an electric field is formed in a particular direction between two opposite electrodes, the light-emitting element ED may be aligned between the two electrodes where polarities are formed.

The light-emitting element ED may have a shape that extends in one direction. The light-emitting element ED may have the shape of a cylinder, a rod, a wire, or a tube, but the shape of the light-emitting element ED is not particularly limited. Alternatively, the light-emitting element ED may have the shape of a polygonal column such as a regular cube, a rectangular parallelepiped, or a hexagonal column or may have a shape that extends in one direction but with a partially inclined outer surface.

The light-emitting element ED may include semiconductor layers doped with a dopant of an arbitrary conductivity type (e.g., a p type or an n type). The semiconductor layers may receive electric signals from an external power source to emit light of a particular wavelength range. The light-emitting element ED may include a first semiconductor layer 31, a second semiconductor layer 32, a light-emitting layer 36, an electrode layer 37, and an insulating film 38.

The first semiconductor layer 31 may include an n-type semiconductor. The first semiconductor layer 31 may include a semiconductor material, i.e., AlₓGa_{y}In_{1-x-y}N (where 0≤x≤1, 0≤y≤1, and 0≤x+y≤1). For example, the first semiconductor layer 31 may include at least one of AlGaInN, GaN, AlGaN, InGaN, AIN, and InN that are doped with an n-type dopant. The n-type dopant may be Si, Ge, Sn, or Se.

The second semiconductor layer 32 may be disposed on the first semiconductor layer 31 with the light-emitting layer 36 interposed therebetween. The second semiconductor layer 32 may include a p-type semiconductor. The second semiconductor layer 32 may include a semiconductor material, i.e., AlₓGa_{y}In_{1-x-y}N (where 0≤x≤1, 0≤y≤1, and 0≤x+y≤1). For example, the second semiconductor layer 32 may include at least one of AlGaInN, GaN, AlGaN, InGaN, AIN, and InN that are doped with a p-type dopant. The p-type dopant may be Mg, Zn, Ca, or Ba.

FIG. 13 illustrates that the first and second semiconductor layers 31 and 32 are formed as single layers, but the disclosure is not limited thereto. Alternatively, each of the first and second semiconductor layers 31 and 32 may include more than one layer such as, for example, a clad layer or a tensile strain barrier reducing (TSBR) layer, depending on the material of the light-emitting layer 36. For example, the light-emitting element ED may further include a semiconductor layer between the first semiconductor layer 31 and the light-emitting layer 36 or a semiconductor layer between the second semiconductor layer 32 and the light-emitting layer 36. The semiconductor layer between the first semiconductor layer 31 and the light-emitting layer 36 may include at least one of AlGaInN, GaN, AlGaN, InGaN, AlN, InN, and SLs (Strained-layer superlattice) that are doped with an n-type dopant, and the semiconductor layer between the second semiconductor layer 32 and the light-emitting layer 36 may include at least one of AlGaInN, GaN, AlGaN, InGaN, AlN, and InN that are doped with a p-type dopant.

The light-emitting layer 36 may be disposed between the first and second semiconductor layers 31 and 32. The light-emitting layer 36 may include a single- or multi-quantum well structure material. In a case where the light-emitting layer 36 includes a material having a multi-quantum well structure, the light-emitting layer 36 may have a structure in which multiple quantum layers and multiple well layers are alternately stacked. The light-emitting layer 36 may emit light by combining electron-hole pairs in accordance with electric signals applied thereto via the first and second semiconductor layers 31 and 32. The light-emitting layer 36 may include a material such as AlGaN, AlGaInN, or InGaN. In particular, in a case where the light-emitting layer 36 has a multi-quantum well structure in which multiple quantum layers and multiple well layers are alternately stacked, the quantum layers may include a material such as AlGaN or AIGalnN, and the well layers may include a material such as GaN, InGaN, or AlInN.

The light-emitting layer 36 may have a structure in which a semiconductor material having a large band gap energy and a semiconductor material having a small band gap energy are alternately stacked or may include group-III or group-V semiconductor materials depending on the wavelength of light to be emitted. The type of light emitted by the light-emitting layer 36 is not particularly limited. The light-emitting layer 36 may emit light of a red or green wavelength range as necessary, instead of blue light.

The electrode layer 37 may be an ohmic connecting electrode, but the disclosure is not limited thereto. Alternatively, the electrode layer 37 may be a Schottky connecting electrode. The light-emitting element ED may include at least one electrode layer 37. The light-emitting element ED may include more than one electrode layer 37, but the disclosure is not limited thereto. Alternatively, the electrode layer 37 may not be provided.

The electrode layer 37 may reduce the resistance between the light-emitting element ED and electrodes or connecting electrodes when the light-emitting element ED is electrically connected to the electrodes or the connecting electrodes. The electrode layer 37 may include a conductive metal. For example, the electrode layer 37 may include at least one of Al, Ti, In, Au, Ag, ITO, IZO, and IZTO.

The insulating film 38 may be disposed to surround the first and second semiconductor layers 31 and 32 and the electrode layer 37. For example, the insulating film 38 may be disposed to surround at least the light-emitting layer 36, but to expose both end portions, in the length direction, of the light-emitting element ED. The insulating film 38 may be formed to be rounded in a cross-sectional view, in a region adjacent to at least one end of the light-emitting element ED.

The insulating film 38 may include a material with insulating properties such as, for example, SiOₓ, SiNₓ, SiOₓN_{y}, aluminium nitride (AlNₓ), aluminium oxide (AlOₓ), zirconium oxide (ZrOₓ), hafnium oxide (HfOₓ), and titanium oxide (TiOₓ). The insulating film 38 is illustrated as being a single-layer film, but the disclosure is not limited thereto. Alternatively, in some embodiments, the insulating film 38 may be formed as a multilayer film in which multiple layers are stacked.

The insulating film 38 may protect the semiconductor layers and the electrode layer. The insulating film 38 can prevent a short circuit that may occur in the light-emitting layer 36 in case that the light-emitting element ED is in direct contact with electrodes to which electric signals are applied. Also, the insulating film 38 can prevent the degradation of the emission efficiency of the light-emitting element ED.

The outer surface of the insulating film 38 may be subjected to surface treatment. The light-emitting element ED may be sprayed on electrodes while being dispersed in predetermined ink. Here, the surface of the insulating film 38 may be hydrophobically or hydrophilically treated to keep the light-emitting element ED dispersed in ink without agglomerating with other neighboring light-emitting elements ED.

Display devices according to other embodiments of the disclosure will hereinafter be described.

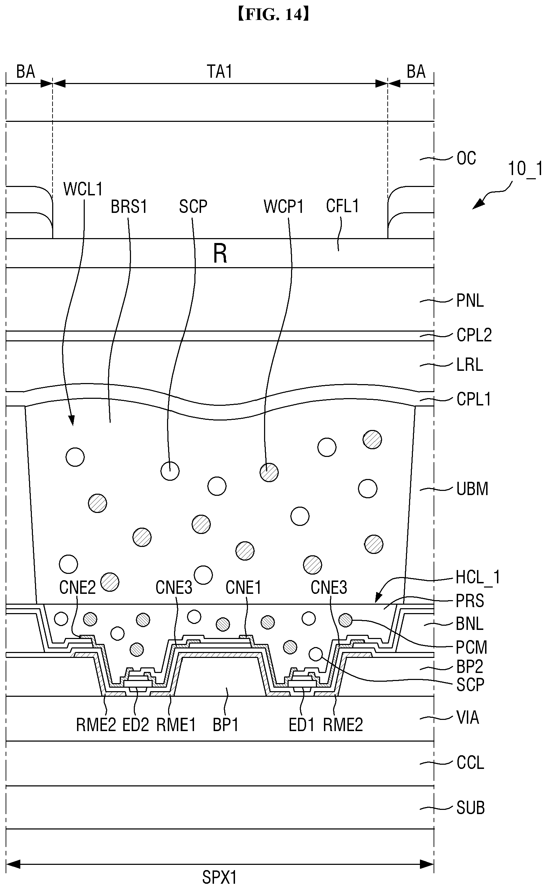

FIG. 14 is a cross-sectional view illustrating a wavelength conversion layer and a thermal control layer in a subpixel of a display device according to another embodiment of the disclosure.

Referring to FIG. 14, a thermal control layer HCL1 of a display device 10_1 may further include a scatterer SCP. As the thermal control layer HCL_1 includes a scatterer SCP, any loss of light emitted from light-emitting elements ED can be minimized, even if the thermal control layer HCL_1 is disposed between a color control layer (TPL, WCL1, and WCL2) and the light-emitting elements ED.

As described above, the thermal control layer HCL_1 may include a resin layer PRS and phase change particles PCM, which are dispersed in the resin layer PRS, and may have a similar structure to the color control layer (TPL, WCL1, and WCL2). The thermal control layer HCL_1 may further include the scatterer SCP, which scatters light emitted by the light-emitting elements ED. The thermal control layer HCL_1, which includes the scatterer SCP, may scatter light incident upon the color control layer (TPL, WCL1, and WCL2) and may provide light emitted by the light-emitting elements ED to the color control layer (TPL, WCL1, and WCL2) at uniform luminance.

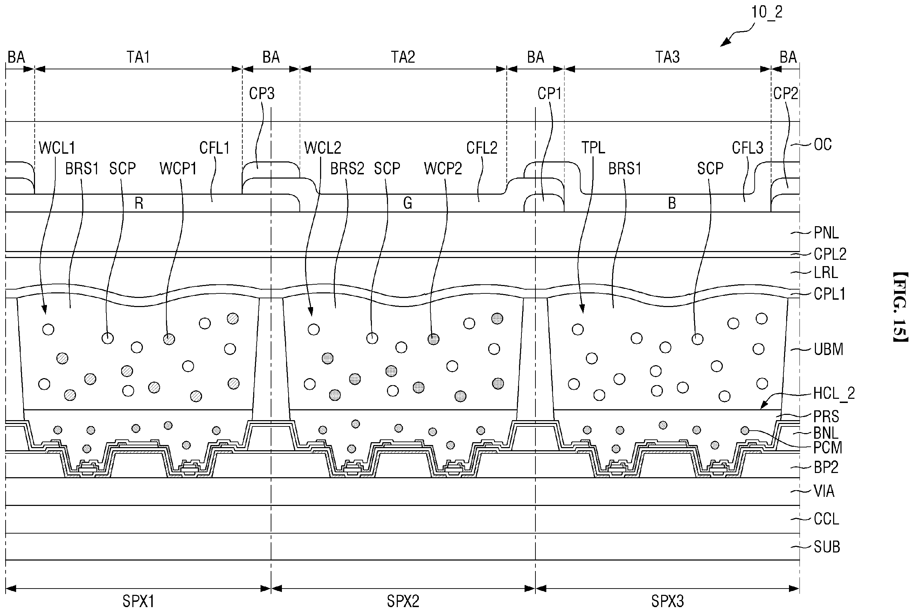

FIG. 15 is a cross-sectional view illustrating a color control layer and a thermal control layer in a pixel of a display device according to another embodiment of the disclosure.

Referring to FIG. 15, a thermal control layer HCL_2 of a display device 10_2 may have a relatively large thickness. The top surface of the thermal control layer HCL_2 may be higher than the top surfaces of uppermost parts of a bank layer BNL, a second insulating layer PAS2, and a third insulating layer PAS3. The thermal control layer HCL_2 may be disposed in part in areas surrounded by an upper bank layer UBM and may be partially in contact with the upper bank layer UBM. The top surface of the thermal control layer HCL_2 may be as high as the upper bank layer UBM.

During the fabrication of the display device 10_2, the thermal control layer HCL_2 may be formed by inkjet printing. In the embodiment of FIG. 15, like in the previous embodiments, if the thermal control layer HCL_2 is printed after the formation of the upper bank layer UBM, the top surface of the thermal control layer HCL_2 may be higher than the top surfaces of the uppermost parts of the bank layer BNL, the second insulating layer PAS2, and the third insulating layer PAS3. A color control layer (TPL, WCL1, and WCL2) may be disposed directly on the thermal control layer HCL_2, in the areas surrounded by the upper bank layer UBM. However, as described above, the thickness of the thermal control layer HCL_2 may be less than the thickness of the color control layer (TPL, WCL1, and WCL2).

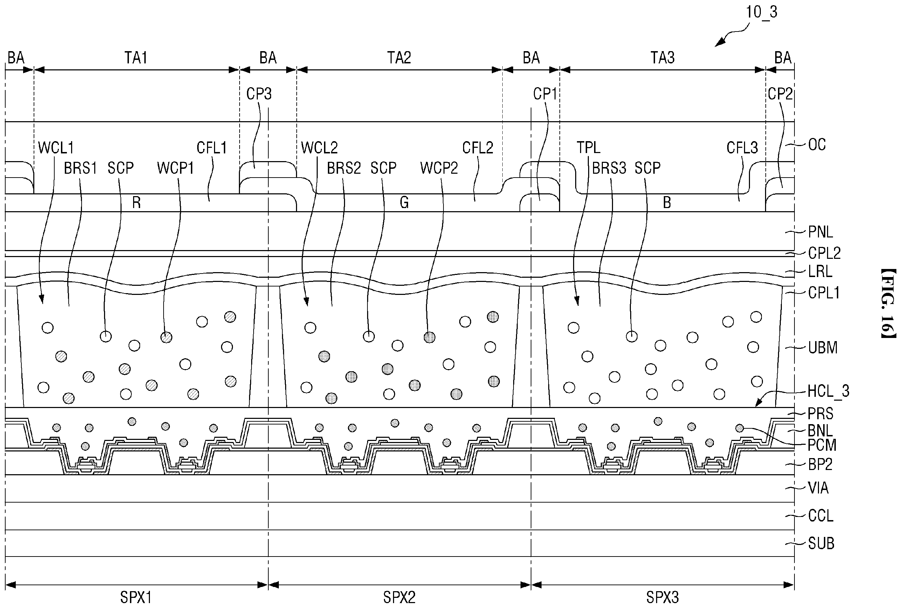

FIG. 16 is a cross-sectional view illustrating a color control layer and a thermal control layer in a pixel of a display device according to another embodiment of the disclosure.

Referring to FIG. 16, a thermal control layer HCL_3 of a display device 10_3 may be disposed over multiple subpixels SPXn. The thermal control layer HCL_3 may be disposed not only in areas surrounded by a bank layer BNL, but also in multiple subpixels SPXn beyond the bank layer BNL. Parts of the thermal control layer HCL_3 may be disposed on the bank layer BNL, and an upper bank layer UBM and a color control layer (TPL, WCL1, and WCL2) may be disposed on the thermal control layer HCL_3.

Unlike in the embodiment of FIG. 15, if the thermal control layer HCL_3 is printed before the formation of the upper bank layer UBM and has a relatively large thickness, the thermal control layer HCL_3 may cover the bank layer BNL. The thermal control layer HCL_3 may include a resin layer PRS and may thus be able to compensate for any height differences, and the upper bank layer UBM and the color control layer (TPL, WCL1, and WCL2) may be disposed directly on the thermal control layer HCL_3. Unlike in the previous embodiments, the upper bank layer UBM may overlap with the bank layer BNL, but the bottom surface of the upper bank layer UBM may be in contact with the thermal control layer HCL_3.

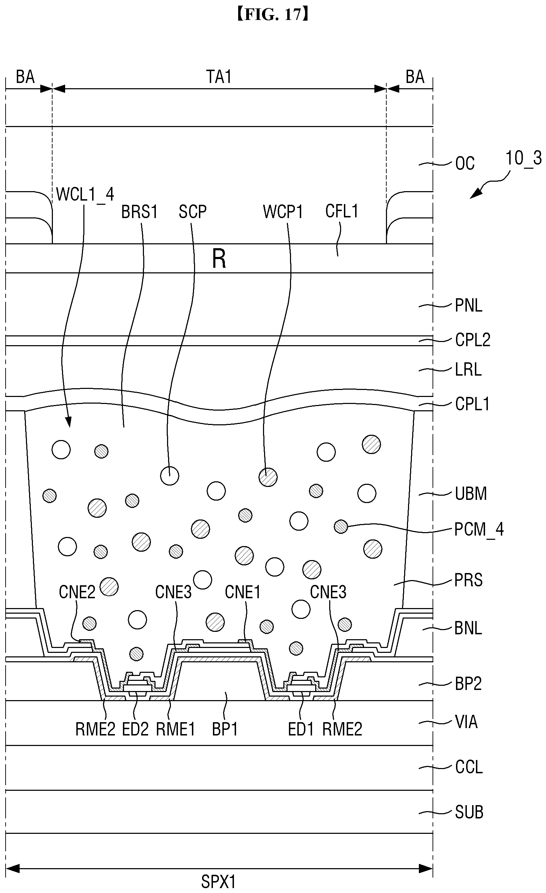

FIG. 17 is a cross-sectional view illustrating a wavelength conversion layer and a thermal control layer in a subpixel of a display device according to another embodiment of the disclosure.

Referring to a display device 10_4 of FIG. 17, a thermal control layer HCL may not be provided, and a color control layer (TPL, WCL1, and WCL2) may include phase change particles PCM_4. The color control layer (TPL, WCL1, and WCL2) may include first, second, and third base resins BRS1, BRS2, and BRS3 and first and second wavelength conversion materials (WCP1 and WCP2) and a scatterer SCP, which are dispersed in the first, second, or third base resin BRS1, BRS2, or BRS3, and may further include the phase change particles PCM_4. As the color control layer (TPL, WCL1, and WCL2) include the phase change particles PCM_4, the thermal control layer (TPL, WCL1, and WCL2) may be able to convert light emitted by light-emitting elements and to control heat generated by the light-emitting elements ED.

In concluding the detailed description, those skilled in the art will appreciate that many variations and modifications may be made to the embodiments without substantially departing from the principles of the disclosure. Therefore, the disclosed embodiments are used in a generic and descriptive sense only and not for purposes of limitation.

## Claims

1. A display device comprising:
a plurality of subpixels, each including a first electrode and a second electrode spaced apart from one another, and light-emitting elements electrically connected to the first electrode and the second electrode;
a bank layer surrounding an area in which the light-emitting elements are disposed;
a thermal control layer disposed in the area surrounded by the bank layer, to cover the light-emitting elements;
an upper bank layer disposed on the bank layer; and
a color control layer disposed on the thermal control layer, in an area surrounded by the upper bank layer,
wherein the thermal control layer includes a resin layer, and a phase change particle dispersed in the resin layer and including a core including a phase change material, and a first shell surrounding the cores.

2. The display device of claim 1, wherein
the core includes at least one of dodecane, docosane, and an aluminium-silicon alloy, and
the first shell includes at least one of polystyrene, polymethylmethacrylate, aluminium oxide, and polymethylmethacrylate-silica.

3. The display device of claim 2, wherein
the phase change particle further includes a second shell surrounding the core and including a thermal conductive material, and
the first shell surrounds the second shell.

4. The display device of claim 3, wherein the second shell includes at least one of graphite, carbon black, and a conductive polymer.

5. The display device of claim 1, wherein the phase change particle has a diameter of 1 µm or less.

6. The display device of claim 1, wherein the resin layer of the thermal control layer includes one of an epoxy resin, an acrylic resin, a cardo resin, and an imide resin.

7. The display device of claim 1, wherein the thermal control layer further includes a scatterer.

8. The display device of claim 8, wherein
the color control layer has a greater thickness than the thermal control layer.

9. The display device of claim 8, wherein
the color control layer has a thickness of 8 µm to 10 µm, and
the thermal control layer has a thickness of about 2 µm.

10. The display device of claim 1, further comprising:
a first insulating layer disposed on the first electrode and the second electrode;
a second insulating layer disposed on the light-emitting elements and the bank layer; and
a third insulating layer disposed on the second insulating layer and the bank layer,
wherein the bank layer is disposed on the first insulating layer.

11. The display device of claim 10, wherein a height of a top surface of the thermal control layer is the same as, or less than, a height of a top surface of the third insulating layer on the bank layer.

12. The display device of claim 10, wherein a height of a top surface of the thermal control layer is greater than a height of a top surface of the third insulating layer on the bank layer.

13. The display device of claim 12, wherein parts of sides of the thermal control layer are in contact with the upper bank layer.

14. The display device of claim 1, wherein
at least a portion of the thermal control layer is disposed on the bank layer, and
the color control layer and the upper bank layer are disposed on the thermal control layer.

15. The display device of claim 1, wherein
the color control layer includes a first wavelength conversion layer disposed in a first subpixel and including a first wavelength conversion particle,
a second wavelength conversion layer disposed in a second subpixel and including a second wavelength conversion particle, and
a light-transmitting layer disposed in a third subpixel and including a scatterer, and
the thermal control layer is disposed between the first wavelength conversion layer, the second wavelength conversion layer, and the light-transmitting layer of the color control layer and the light-emitting elements.

16. The display device of claim 1, further comprising:
a first connecting electrode in contact with the light-emitting elements and disposed on the first electrode; and
a second connecting electrode in contact with the light-emitting elements and disposed on the second electrodes.

17. A display device comprising:
a plurality of subpixels, each including a first electrode and a second electrode spaced apart from one another, and light-emitting elements electrically connected to the first electrode and the second electrode;
a bank layer surrounding an area in which the light-emitting elements are disposed;
an upper bank layer disposed on the bank layer; and
a color control layer disposed on the light-emitting elements, in an area surrounded by the upper bank layer,
wherein
the color control layer includes a first wavelength conversion layer disposed in a first subpixel and including a first wavelength conversion particle,
a second wavelength conversion layer disposed in a second subpixel and including a second wavelength conversion particle, and
a light-transmitting layer disposed in a third subpixel and including a scatterer, and
the first wavelength conversion layer, the second wavelength conversion layer, and the light-transmitting layer include a phase change particle including a core including a phase change material, and a first shell surrounding the core.

18. The display device of claim 17, wherein
the core includes at least one of dodecane, docosane, and an aluminium-silicon alloy, and
the first shell includes at least one of polystyrene, polymethylmethacrylate, aluminium oxide, and polymethylmethacrylate-silica.

19. The display device of claim 18, wherein
the phase change particle further includes a second shell surrounding the core and including a thermal conductive material, and
the first shell surrounds the second shell.

20. The display device of claim 17, wherein the phase change particle has a diameter of 1 µm or less.
